# EUROPÄISCHE PATENTSCHRIFT

(11) **EP 1 025 329 B1**
(45) Veröffentlichungstag und Bekanntmachung des Hinweises auf die Patenterteilung: **03.03.2004**
(21) Anmeldenummer: 99927794.0
(22) Anmeldetag: 28.05.1999
(51) Int. Cl.: E06B 3/54

(54) **BEFESTIGUNGSVORRICHTUNG FÜR EINE GLASPLATTE AN EINER GEBÄUDESEITIGEN HALTERUNG**
DEVICE FOR FIXING A GLASS PANEL TO A SUPPORT AT THE SIDE OF A BUILDING
DISPOSITIF POUR FIXER UN PANNEAU DE VERRE SUR UN SUPPORT PLACE COTE BATIMENT

(30) Priorität: 04.06.1998 AT 95498; 06.04.1999 DE 19915193
(43) Veröffentlichungstag der Anmeldung: 09.08.2000
(73) Patentinhaber: DORMA GmbH + Co. KG, 58256 Ennepetal (DE)
(72) Erfinder: ELMER, Hubert, A-6065 Thaur (AT)
(86) Internationale Anmeldenummer: PCT/EP1999/003721
(87) Internationale Veröffentlichungsnummer: WO 1999/063193

(56) Entgegenhaltungen:
- EP-A- 0 784 129
- DE-A- 3 927 653
- DE-A- 4 400 979
- DE-A- 4 445 724
- DE-A- 19 519 526
- DE-A- 19 519 527
- DE-A- 19 528 489
- DE-U- 29 617 870

## Beschreibung

Die Erfindung betrifft eine Befestigungsvorrichtung für ein mindestens einflächiges voltaisches Element mit Leitungen für die Ableitung von Strom aufweisende Glasplatte an einer gebäudeseitigen Halterung mit einem außenseitigen und einem innenseitigen, die Glasplatte zwischen sich einspannenden Klemmelement und einer Abstützung der Befestigungsvorrichtung an dem innenseitigen Klemmelement, wobei das innenseitige Klemmelement an seiner im Einbauzustand der Glasplatte abgewandten ersten Mantelfläche eine durch ein dauerelastisches Federglied gebildete kegelige oder ballige Mantelfläche aufweist, gegen die eine erste Komplementärfläche eines Innenmantels einer Überwurfglocke mit einstellbarer Vorspannung anstellbar ist, und wobei zwischen der Überwurfglocke und einer Befestigungsschraube ein verstarrbares Raumgelenk angeordnet ist.

Durch die DE 195 19 527 A ist eine raumgelenkige Abstützung einer Befestigungsvorrichtung bekannt geworden, bei der ein mit der gebäudeseitigen Halterung verbundener Träger an einem gebäudeinnenseitigen Klemmelement abgestützt ist. Die Abstützung erfolgt mittels eines in einer Lagerkammer des Klemmelementes in Achsrichtung des Trägers elastisch nachgiebig gelagerten Lagerkopfes des Trägers, wobei der Lagerkopf zusätzlich mit seitlichem Spiel in der Lagerkammer gelagert ist, um ein Verschieben des Trägers bzw. seines Lagerkopfes parallel zur Ebene der Glasplatte bei Einwirkung von Winddruck zu ermöglichen. Die elastische Nachgiebigkeit des Lagerkopfes wird durch Tellerfedern oder ein dauerelastisches Material bewirkt, dessen Anordnung in der Lagerkammer ständig eine Rückstellkraft auf den Träger bzw. die Glasscheibe im Sinne einer Positionierung des Trägers orthogonal zur Glasscheibe bewirkt, was letztlich die Einleitung von Spannungen in die Glasscheibe zur Folge hat. Außerdem können größere Toleranzen zwischen der Bohrung in der Glasscheibe und dem Anschlusspunkt an der gebäudeseitigen Halterung nicht ausgeglichen werden.

Die DE 44 00 979 A1 offenbart ebenfalls eine raumgelenkige Abstützung, bei der das gebäudeinnenseitige Klemmelement (Aufnahmelager) an der der Halterung zugewandten Mantelfläche eine kugelige Oberfläche aufweist, an der ein Ausgleichsteil mit komplementärer Kugelkalottenfläche anliegt. Das Klemmelement besitzt eine Durchgangsbohrung für die Aufnahme der die Klemmelemente verbindenden Klemmschraube und einer ein Unterlegteil und das Ausgleich steil durchfassende und in das Klemmelement einfassenden Halteschraube. Mit der bekannten Vorrichtung können Bautoleranzen zwischen der Bohrung in einer Glasscheibe und einer Unterkonstruktion (Halterung) ausgeglichen werden, eine federnd elastische Abstützung der Scheibe an der Halterung nach erfolgter Montage ist nicht vorgesehen.

Eine ähnliche Vorrichtung beschreibt die DE 44 45 724 A1, bei der das gebäudeinnenseitige Klemmelement an seiner der Halterung zugewandten Mantelfläche eine kugelige Oberfläche aufweist, an der ein Schwenklager eines Befestigungsteiles seiner Komplementärfläche anliegt, wobei das Schwenklager mit seitlichem Spiel in einer Überwurfmutter gehalten ist. Nach erfolgter Montage ist auch hier eine Relativbewegung der Scheibe gegenüber dem Befestigungsteil nicht mehr möglich.

Ferner ist aus der EP 0 784 129 A2 eine Abstützung einer Befestigungsschraube an einer Halterung bekannt, bei der eine Platte der Halterung zwischen zwei plankonvexen Linsen festgelegt ist, die mit ihren Planflächen mittelbar an der Platte anliegen, wobei eine Linse mit ihrer konvexen Fläche an einem gebäudeinnenseitigen Klemmelement und die andere Linse mittelbar an einer die Befestigungsschraube aufnehmenden Mutter anliegt.

Die DE 296 178 70 U1 beschreibt ein Solar-Fassadenelement, welches auch für Dacheindeckungen geeignet ist und aus einem Fassadenelement mit integriertem Photovoltaik-Solar-Modul besteht. Zur Ableitung des Stromes weist jedes Fassadenelement Kontaktstellen auf, die an eine gemeinsame Leitung anschließbar sind.

Die EP 0 417 303 A1 befasst sich mit einer auf einem Dach montierbaren Anlage zur solaren Stromgewinnung, deren Konstruktion einer Anpassungsmöglichkeit an Fertigungstoleranzen des Daches oder in das Dach eingeleitete Wärmespannungen, insbesondere bei der Überbrückung der Dachfirst, ermöglicht. Die Stromabnahme ist nicht Gegenstand der Anmeldung, sie erfolgt offensichtlich in der bei Sonnenkollektoren üblichen Weise in mittels einer das Dach durchfassenden Leitung.

Bei der Befestigung von hochempfindlichen Glasplatten, beispielsweise in Verbindung mit Siliciumscheiben, für die photovoltäre Stromerzeugung genügen die vorbekannten Befestigungsvorrichtungen den an sie gestellten Anforderungen nicht. Bereits bei geringem Winddruck bzw. bei relativ geringen Verformungen aufgrund von Wärmeeinleitung kommt es zum Bruch der Siliciumelemente und damit zum Verlust des bestimmungsgemäßen Zweckes der Glasplatte.

Aufgabe der Erfindung ist es, eine Befestigungsvorrichtung der eingangs genannten Gattung dahingehend zu verbessern, dass zum einen eine spannungsfreie Anpassung der Befestigungsvorrichtung unter Berücksichtigung auch größerer Bautoleranzen bei der Montage möglich ist, dass zum anderen nach erfolgter Montage zwischen der Befestigungsvorrichtung und der Glasplatte eine ausreichende Elastizität verbleibt, um Winddruck oder Wärmespannungen ohne Einleitung von Spannungen in die Glasplatte von der Befestigungsvorrichtung aufnehmen zu können.

Die Erfindung löst die gestellte Aufgabe durch die Lehre nach Anspruch 1.

Hiernach weist ein innenseitiges Klemmelement an seiner die Glasplatte im Einbauzustand abgewandten Glasfläche eine durch ein dauerelastisches Federglied gebildete kegelige oder ballige Mantelfläche auf, gegen die eine Komplementärfläche eines Innenmantels einer Überwurfglocke mit einstellbarer Vorspannung anstellbar ist, wobei zwischen der Überwurfglocke und einer Befestigungsschraube einerseits und einer Befestigungsschraube und der Halterung andererseits jeweils ein verstarrbares Raumgelenk angeordnet ist und Leitungen für die Ableitung von Strom durch die Befestigungsvorrichtung durchführbar sind.

Nach der erfindungsgemäßen Lösung werden Winddruck und Wärmespannungen durch die elastische Abstützung der Überwurfglocke an dem innenseitigen Klemmelement aufgefangen, weil auch nach erfolgter Montage eine Relativbewegung der beiden Teile zueinander, ohne die Einleitung von Rückstellkräften in die Glasplatte, möglich ist. Dies ist gewährleistet durch die einstellbare Vorspannung zwischen Klemmelement und Überwurfglocke. Durch die mehrfache Untergliederung der Befestigungsvorrichtung durch mindestens zwei weitere Raumgelenke ist nicht nur eine gute Anpassungsmöglichkeit an größere Bautoleranzen gegeben; die einzelnen Gelenkpunkte der Raumgelenke bilden auch bei fester Verspannung nach der Montage gewissermaßen Knotenpunkte mit einer gewissen Eigenelastizität, die zusätzlich zur spannungsfreien Lagerung der Glasplatte beitragen.

Die Befestigungsvorrichtung erfüllt dabei eine Doppelfunktion. Da die Ableitung des Stromes durch die Befestigungsvorrichtung erfolgt, kann auf gesonderte Abnahmeelemente verzichtet werden.

Weitere Merkmale der Erfindung sind durch die Unteransprüche gekennzeichnet.

Das innenseitige Klemmelement kann nach einer Ausführungsform der Erfindung selbst an seiner der Glasplatte abgewandten Mantelfläche eine kegelige oder ballige Mantelfläche aufweisen, prinzipiell kann die kegelige oder ballige Mantelfläche auch bei planer Ausbildung des Klemmelementes durch das dauerelastische Federglied gemäß Anspruch 1 gebildet werden. Ferner ist im innenseitigen Klemmelement eine ein Innengewinde aufweisende zentrische Durchgangsbohrung für die Aufnahme einer die Klemmelemente verbindende Klemmschraube und einer die Überwurfglocke mit dem innenseitigen Klemmelement verbindende Überwurfglokken-Einstellschraube vorgesehen, wobei in Ausgestaltung der Erfindung das dauerelastische Federglied als dauerelastisches Kissen ausgebildet ist, welches zwischen der der Glasplatte zugewandten kegeligen oder balligen Mantelfläche des innenseitigen Klemmelementes und der Komplementärfläche der Überwurfglocke angeordnet ist. Mittels der vorbeschriebenen Überwurfglocken-Einstellschraube kann das dauerelastische Kissen so eingespannt werden, dass nicht nur vom dauerelastischen Kissen selbst in die Glasplatte eingeleitete Spannungen aufgenommen werden können, sondern dass eine Relativverschiebung der Überwurfglocke gegenüber dem dauerelastischen Kissen möglich ist, so dass im Einbauzustand die Glasplatte völlig spannungsfrei gelagert ist.

Nach einem besonderen Merkmal der Erfindung weist die Überwurfglocke an ihrer der Halterung im Einbauzustand zugewandten Seite einen mit einem Außengewinde versehenen zylindrischen Fortsatz auf, zwischen dem und der Überwurfglocke im Bereich des Bodentiefsten der Überwurfglocke ein nach innen gerichteter Flansch für die Abstützung des Schraubenkopfes der Überwurfglocken-Einstellschraube ausgebildet ist. Dabei ermöglicht ein zwischen dem Flansch und einem Schaft der Überwurfglocken-Einstellschraube vorgesehenes Spiel die Anordnung einer als Linse ausgebildeten Scheibe zwischen dem Flansch und dem Schraubenkopf der Überwurfglocken-Einstellschraube derart, dass der Schaft der Überwurfglocken-Einstellschraube gegenüber der Überwurfglocke eine Pendelbewegung ausüben kann. Diese Pendelbewegung wird begünstigt, wenn die Anlagefläche des Flansches und die Komplementärfläche der Linse kegelig oder ballig verlaufend ausgebildet sind. Es hat sich als zweckmäßig erwiesen, hierfür eine nicht metallische, beispielsweise aus einem gleitfähigen Hartgummi bestehende Linse zu verwenden. Auf diese Weise wird praktisch ein zusätzliches Raumgelenk zwischen der Überwurfglocke und dem innenseitigen Klemmelement und damit der Glasplatte geschaffen.

Ein weiteres Raumgelenk besteht darin, dass die gegen die Halterung gerichtete Stirnfläche des Fortsatzes der Überwurfglocke konkav linsenförmig gekrümmt ist, wobei eine das Außengewinde des Fortsatzes der Überwurfglocke überfassende topfartige Überwurfmutter eine innere Topfbodenfläche aufweist, die entsprechend gegensinnig zur Stirnfläche des Fortsatzes der Überwurfglocke gekrümmt ist, so dass zwischen der Stimfläche des Fortsatzes der Überwurfglocke und der Topfbodenfläche der Überwurfmutter zwei mit ihren Planflächen aneinander liegende konvexe Linsen gelagert sein können. Mittels der vorbeschriebenen Überwurfmutter kann das vorbeschriebene Raumgelenk nach erfolgter Montage verstarrt werden.

In einer vorteilhaften Ausgestaltungsform der Erfindung ist die der Topfbodenfläche der Überwurfmutter anliegende plankonvexe Linse Bestandteil einer die Befestigungsschraube aufnehmenden ersten Mutter, wodurch die Möglichkeit gegeben ist, die Befestigungsschraube mehr oder weniger tief in die erste Mutter zum Zwecke einer gewünschten Verkürzung oder Verlängerung der ganzen Befestigungsvorrichtung einzuschrauben. Zur Erzielung des vorgenannten Raumgelenkes ist der Schaft der ersten Mutter so dimensioniert, dass er eine Bohrung im Topfboden der Überwurfmutter mit Spiel durchfasst.

Ein weiteres Raumgelenk kann in an sich bekannter Weise im Bereich der unmittelbaren Verbindung der Befestigungsschraube mit der Halterung dadurch realisiert werden, dass die Befestigungsschraube eine Bohrung in der Halterung mit Spiel durchfasst und die Halterung zwischen einer zweiten Mutter und einer Kontermutter festgelegt ist, wobei zwischen der zweiten Mutter und der Kontermutter einerseits und der Halterung andererseits jeweils eine plankonvexe, mit ihrer Planfläche der Halterung anliegende Linse vorgesehen ist und die zweite Mutter und Kontermutter zur Linse komplementäre Anlageflächen aufweisen. Auch hierbei handelt es sich bei der Montage um ein einstellbares und anpassbares und nach erfolgter Montage verstarrbares Raumgelenk, wobei zwischen dem letztgenannten, den Anschluss an die Halterung bildenden Raumgelenk und dem durch die Überwurfglocke und die Überwurfmutter gebildeten Raumgelenk, eine Distanzhülse vorgesehen sein kann.

Die Ausbildung des die Glasplatte einspannenden, gebäudeaußenseitigen Klemmelementes kann grundsätzlich beliebig sein, sie kann in an sich bekannter Weise als Klemmteller oder als Senkschraube ausgebildet sein, ohne die mit der Erfindung erzielbare spannungsfreie Befestigung der Glasplatte zu beeinflussen.

Erfindungsgemäß sind Leitungen mindestens eines voltaischen Elementes für die Ableitung von Strom durch den Befestigungsbeschlag durchführbar. Vorteilhaft ist vorgesehen, dass der Befestigungsbeschlag zwei miteinander kuppelbare - vorzugsweise verschraubbare - Halterungsteller umfasst, zwischen denen die Glasscheibe im Einbauzustand gehalten ist, wobei die Ableitung von Strom radial zwischen den Halterungstellern eintreten und axial bei einem Halterungsteller austreten kann. Damit die Leitungen für die Ableitung von Strom ungehindert durch den Halter für die Glasscheibe durchgeführt werden können, ist in einem Ausführungsbeispiel der Erfindung vorgesehen, dass die Halterungsteller mittels separater Schrauben, die vorzugsweise im Bereich von zylindrischen Ansätzen angeordnet sind, verschraubt sind. Vorteilhaft werden die Leitungen innerhalb der Glasscheibe von flachen Metallstreifen gebildet, die im Bereich der Halterungsteller mittels Steckverbindungen an Runddrähte oder Litzen angeschlossen sind. Über die Runddrähte bzw. Litzen wird der Strom zum Gebäude abgeleitet. Um eine Oxidierung der Leitungen im Steckbereich zu vermeiden, ist in einem Ausführungsbeispiel der Erfindung vorgesehen, dass die Aussparung mit einem nicht leitenden Kunststoffmaterial, Wachs oder dergleichen ausgegossen ist und die Leitungen in dieses Material eingebettet sind. Vorteilhaft wird als Kunststoffmaterial Polyurethan eingesetzt.

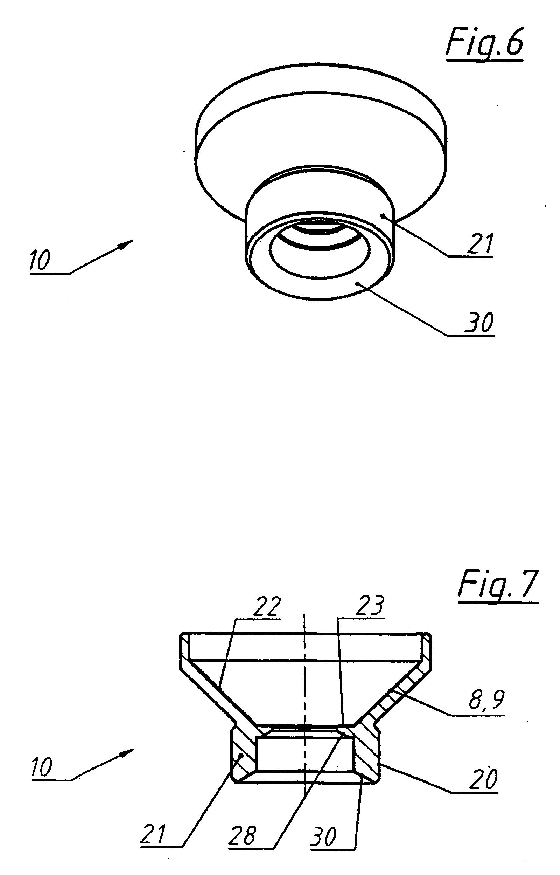

Die Erfindung wird nachfolgend anhand verschiedener Ausführungsbeispiele näher erläutert. Die Figuren 1 bis 13 zeigen schematisch die spannungsfreie Anpassung der Befestigungsvorrichtung unter Fortlassung der Stromdurchführung.

Es zeigen:
- Figur 1:: Einen Querschnitt durch eine Befestigungsvorrichtung.
- Figur 2:: Den Querschnitt nach Figur 1 bei gegenüber der Halterung abgewinkelter Glasplatte.
- Figur 3:: Den Querschnitt nach Figur 1 mit geändertem außenseitigen Klemmelement.
- Figuren 4 - 13:: Einzelheiten des innenseitigen Klemmelementes, der Überwurfglocke, der der Schraubenglocke der Überwurfglocken-Einstellschraube anliegenden Linse, der die Befestigungsschraube aufnehmenden Mutter und der Überwurfmutter, jeweils in perspektivischer Ansicht und im Querschnitt.

Die Figuren 14 bis 22 zeigen schematisch die Ableitung von Strom unter Fortlassung einer spannungsfreien Anpassung der Befestigungsvorrichtung.

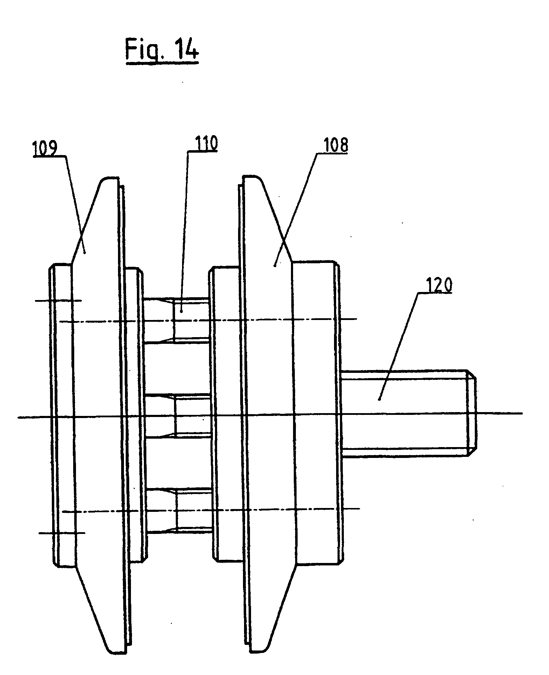

- Figur 14:: Eine Seitenansicht auf einen erfindungsgemäßen Befestigungsbeschlag.

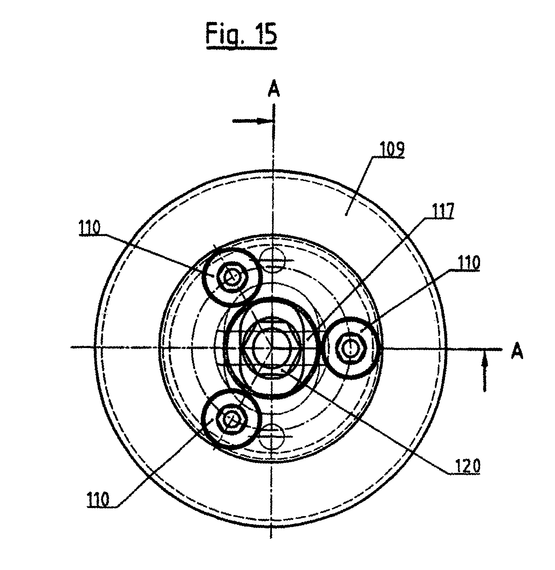

- Figur 15:: Eine Draufsicht auf den äußeren Halterungsteller des Befestigungsbeschlages.

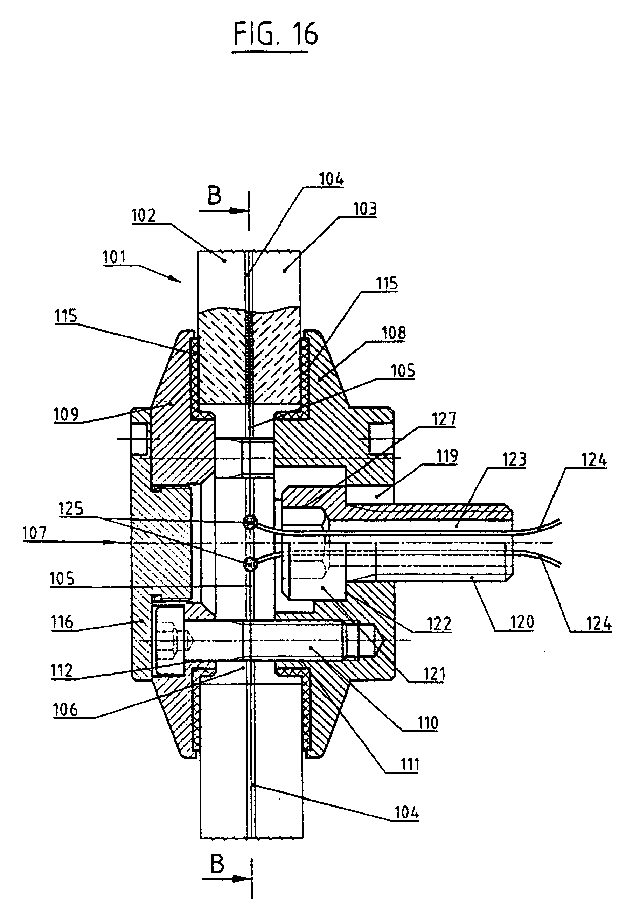

- Figur 16:: Einen Schnitt nach der Linie A-A der Figur 15.

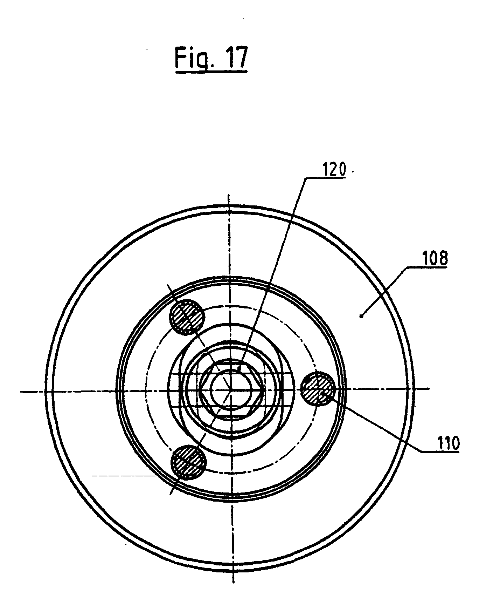

- Figur 17:: Einen Schnitt nach der Linie B-B der Figur 16.

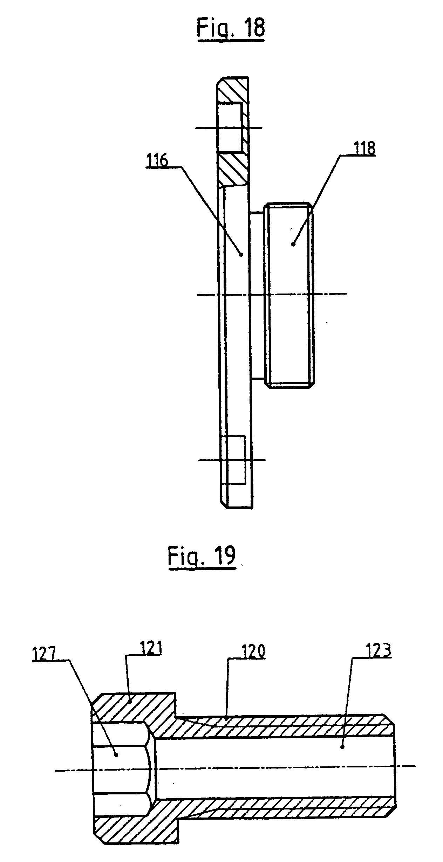

- Figur 18:: Eine Seitenansicht einer Abdeckung.
- Figur 19:: Einen Axialschnitt durch eine Befestigungsschraube.

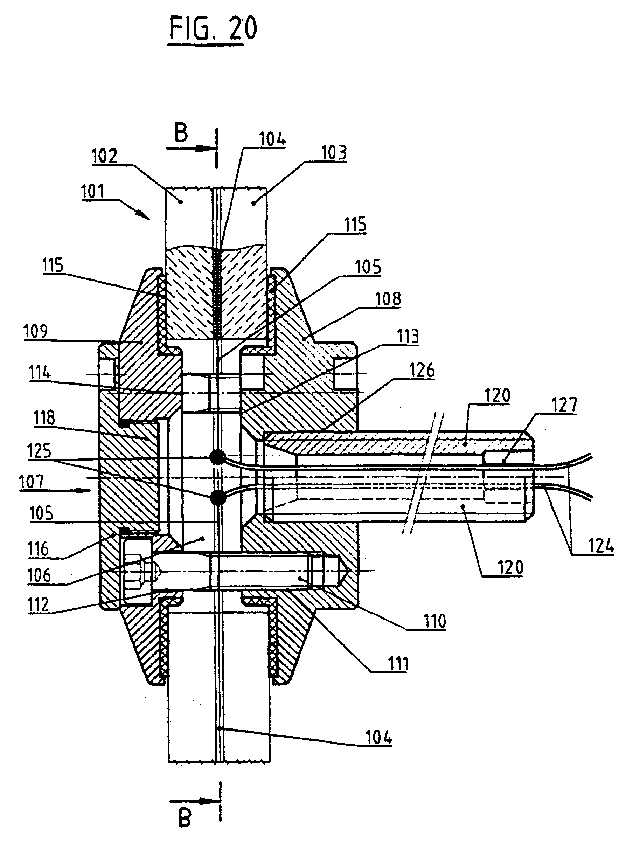

- Figur 20:: Einen Schnitt analog der Figur 16 gemäß einem weiteren Ausführungsbeispiel der Erfindung.

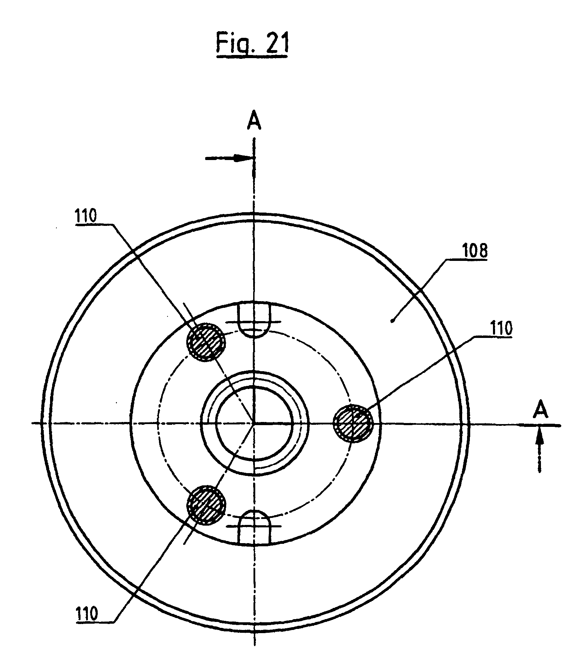

- Figur 21:: Einen Schnitt nach der Linie B-B nach der Figur 20.

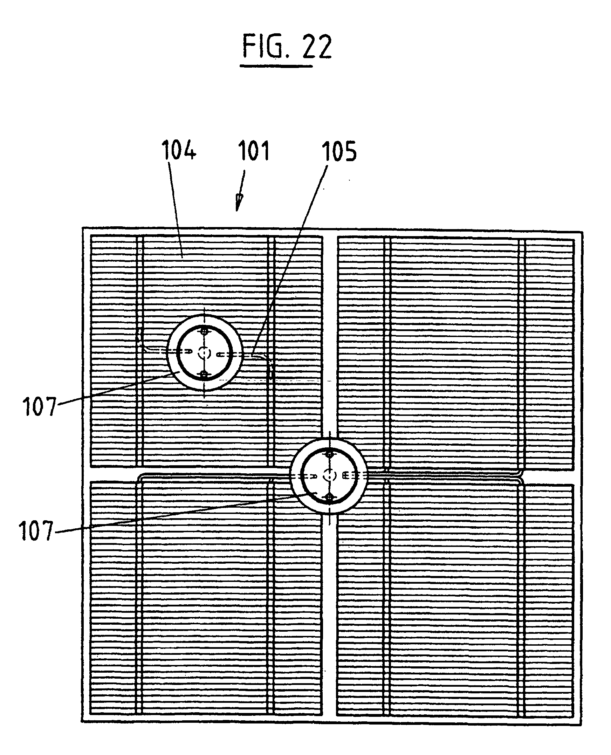

- Figur 22:: Eine Draufsicht auf eine erfindungsgemäße Glasscheibe.

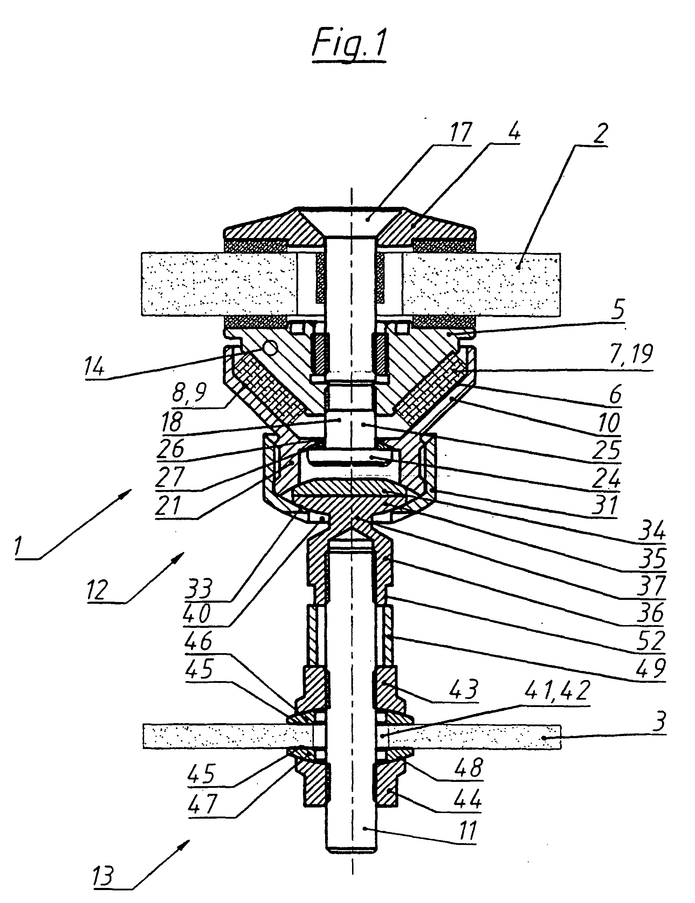

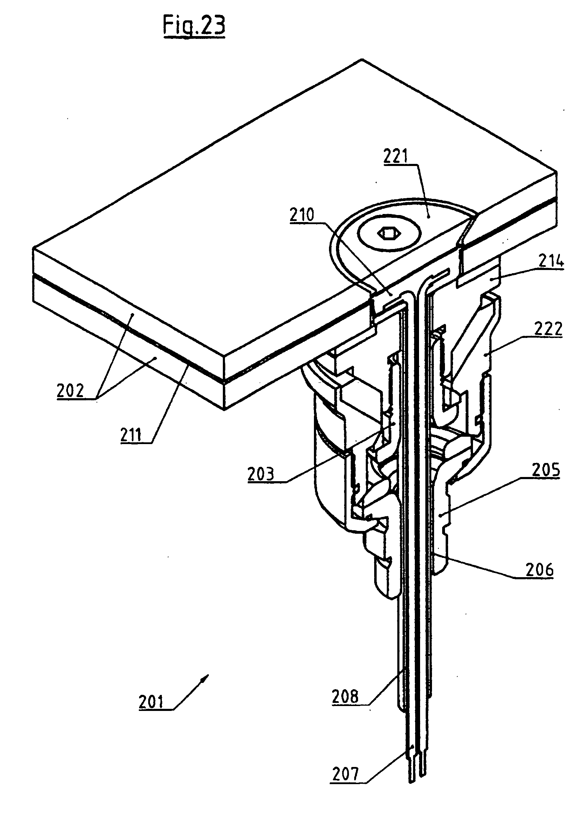

Die Figuren 23 bis 46 zeigen eine Ausführungsform der spannungsfreien Anpassung der Befestigungsvorrichtung unter Verwendung der wesentlichen Bauteile der Ausführungsform nach Figur 1 mit einer Durchführung der stromabführenden Leitungen durch die Befestigungsvorrichtung.
- Figur 23:: Die Befestigungsvorrichtung in einem Vertikalschnitt in perspektivischer Darstellung.

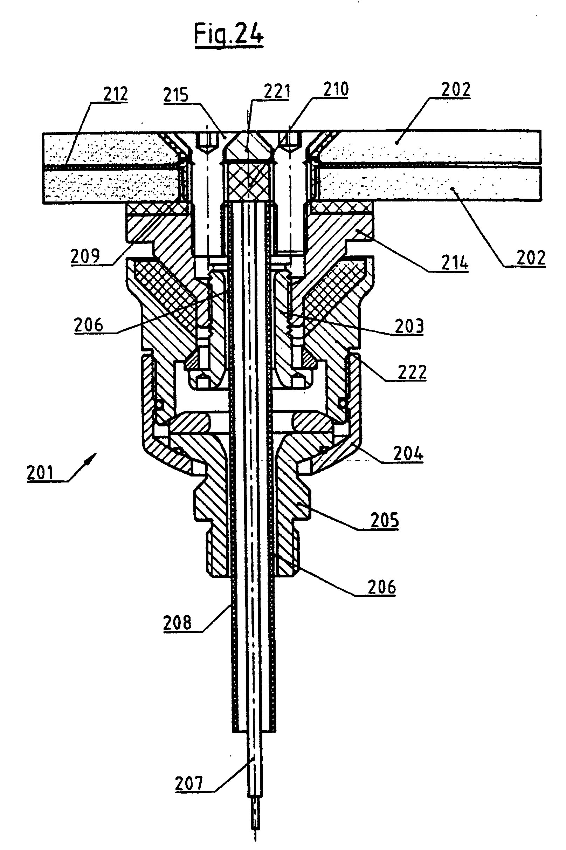

- Figur 24:: Einen Vertikalschnitt in gegenüber Figur 23 um 90 Grad versetzter Darstellung.

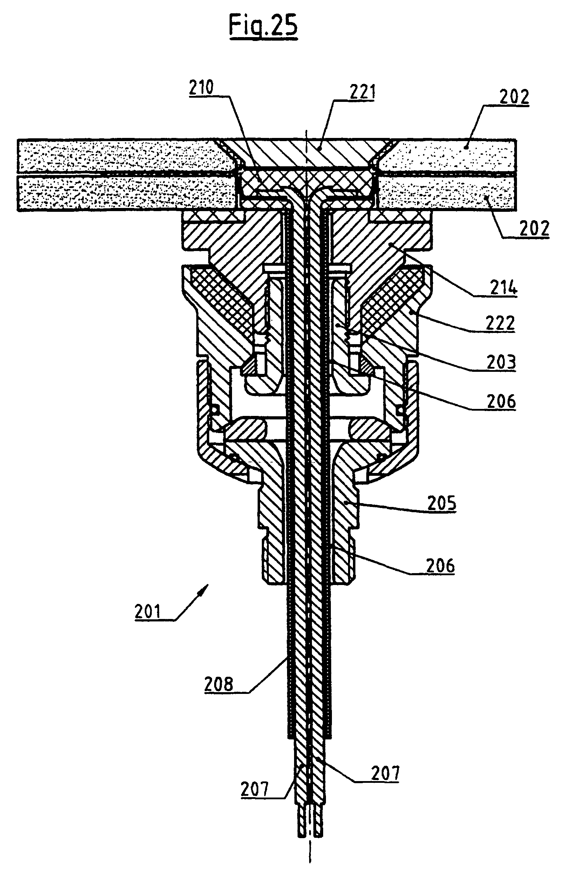

- Figur 25:: Einen Vertikalschnitt entsprechend Figur 23.

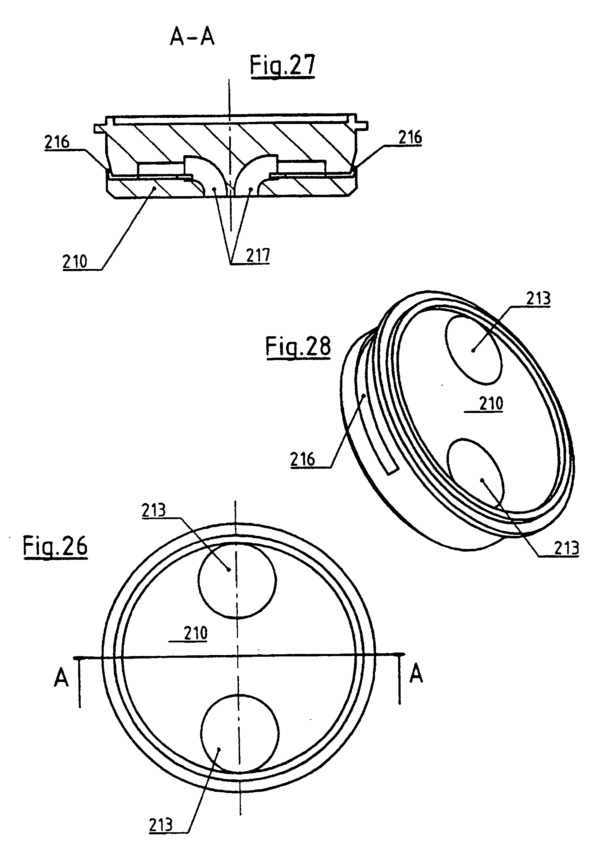

- Figur 26:: In vergrößerter Darstellung eine Draufsicht auf den Isolator.
- Figur 27:: Den Schnitt nach der Linie A-A gemäß Figur 26.
- Figur 28:: Eine perspektivische Darstellung des Isolators.

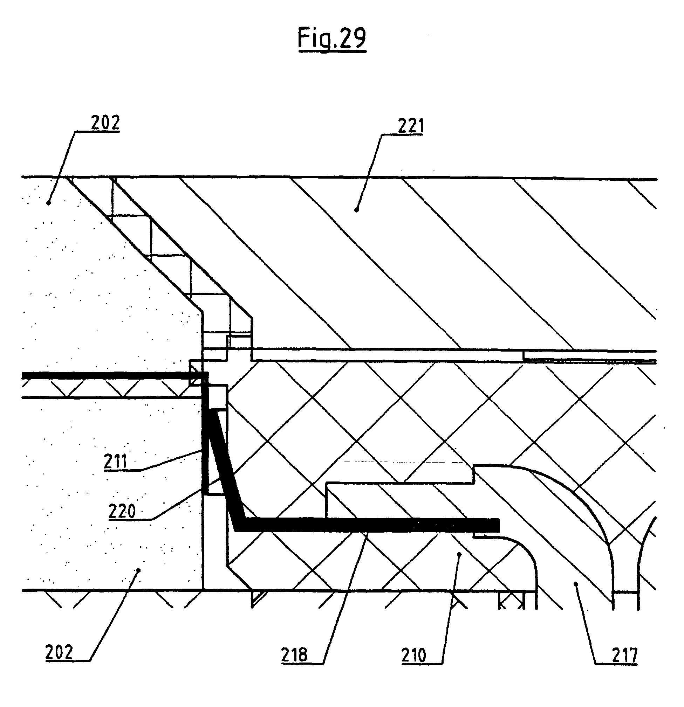

- Figur 29:: Ein Detail der Stromabnahme in vergrößerter Darstellung.

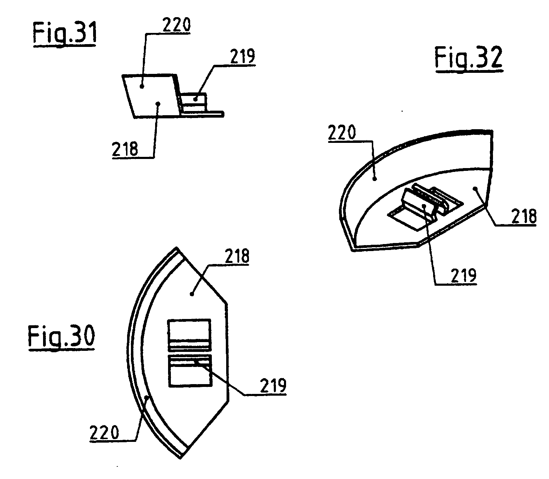

- Figur 30:: Das Kontaktstück in einer Draufsicht in vergrößerter Darstellung.
- Figur 31:: Das Kontaktstück in einer Seitenansicht.
- Figur 32:: Das Kontaktstück in perspektivischer Darstellung.

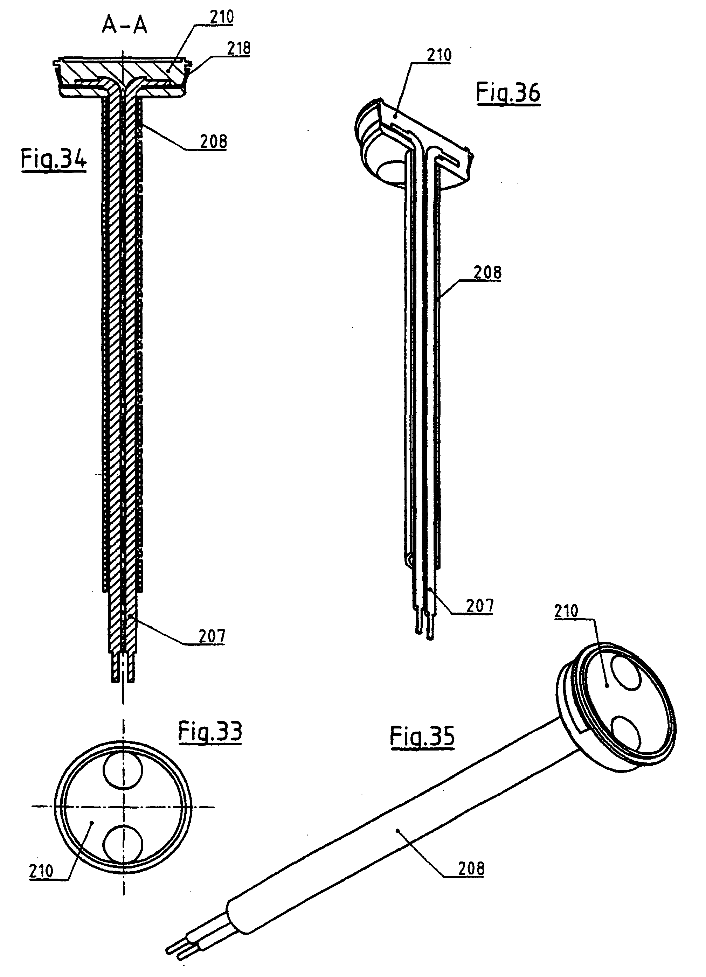

- Figur 33:: Eine Draufsicht auf den Isolator entsprechend Figur 26.
- Figur 34:: Den Schnitt nach der Linie A-A gemäß Figur 33.
- Figur 35:: Eine perspektivische Darstellung des Isolators mit angeschlossenem Schrumpfschlauch.
- Figur 36:: Einen perspektivischen Vertikalschnitt durch den Isolator mit angeschlossenem Schrumpfschlauch.

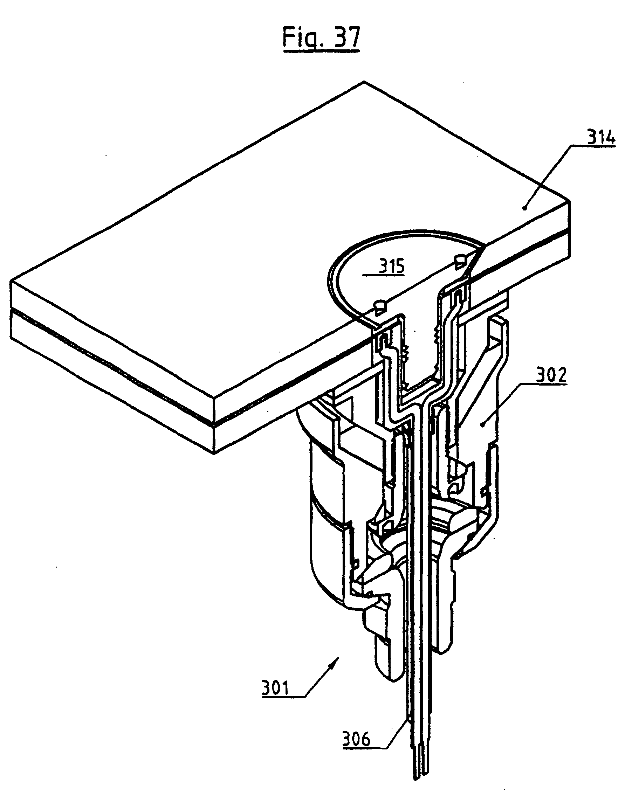

Die Figuren 37 bis 53 zeigen eine weitere Ausführungsform der spannungsfreien Anpassung der Befestigungsvorrichtung unter Verwendung der wesentlichen Bauteile der Ausführungsform nach Figur 1 mit einer weiteren Ausgestaltung einer Durchführung der stromabführenden Leitungen durch die Befestigungsvorrichtung.
- Figur 37:: Die Befestigungsvorrichtung in einem Vertikalschnitt in perspektivischer Darstellung.

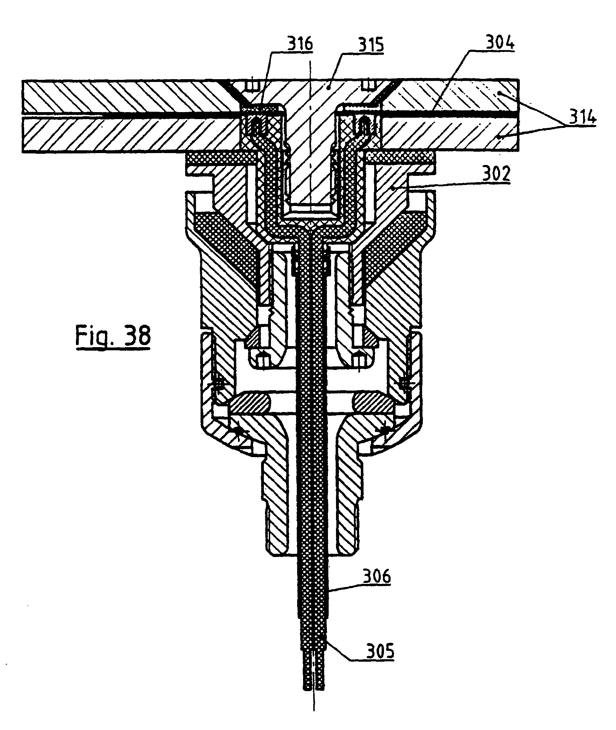

- Figur 38:: Einen Vertikalschnitt entsprechend Figur 37.

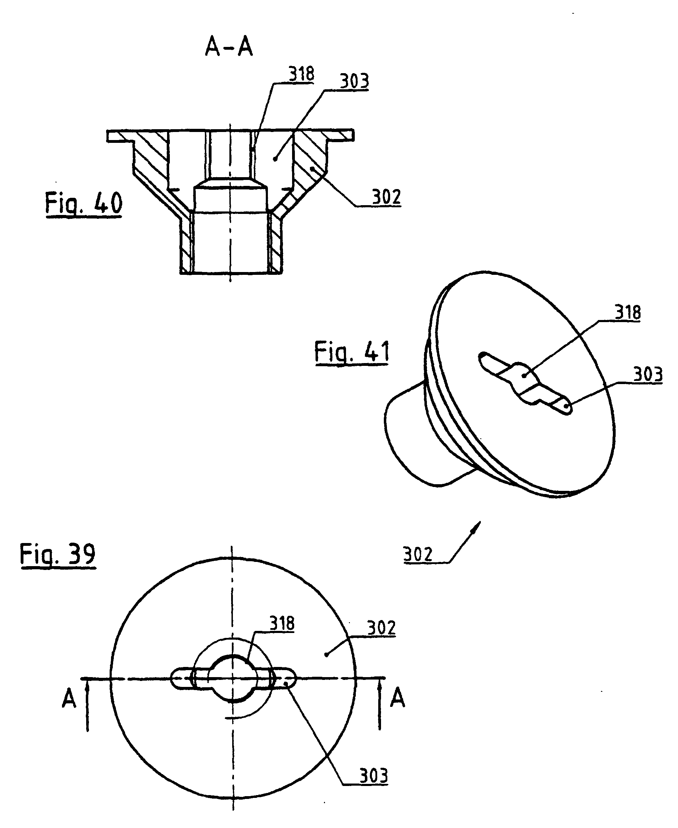

- Figur 39:: Eine Draufsicht auf das gebäudeinnenseitige Klemmelement.
- Figur 40:: Einen Schnitt nach der Linie A-A gemäß Figur 39.
- Figur 41:: Das gebäudeinnenseitige Klemmelement in perspektivischer Darstellung.

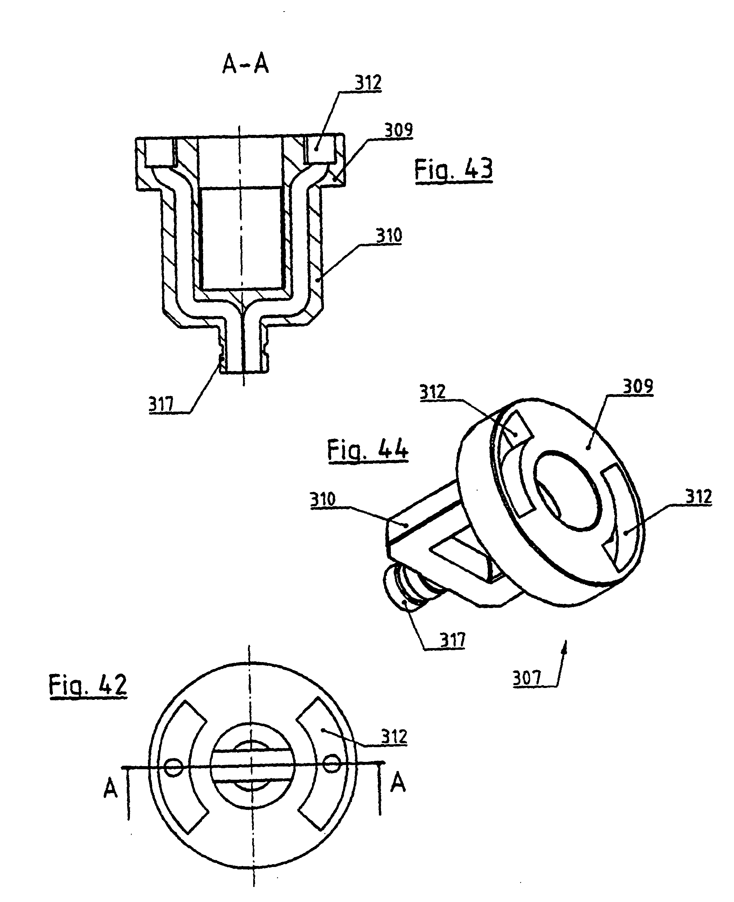

- Figur 42:: Eine Draufsicht auf den Korb.
- Figur 43:: Den Schnitt nach der Linie A-A gemäß Figur 42.
- Figur 44:: Den Korb in perspektivischer Darstellung.

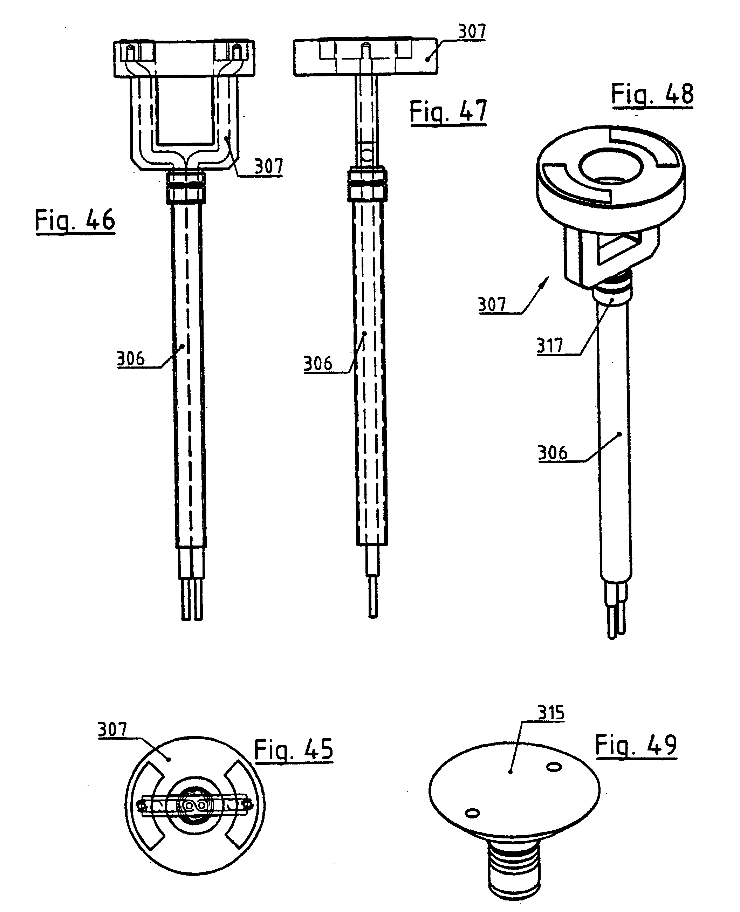

- Figur 45:: Eine Draufsicht auf den Korb mit angeschlossenem Schrumpfschlauch.
- Figuren 46 und 47:: Zwei Ansichten der Korb-Baugruppe.
- Figur 48:: Den Korb mit Schrumpfschlauch in perspektivischer Darstellung.

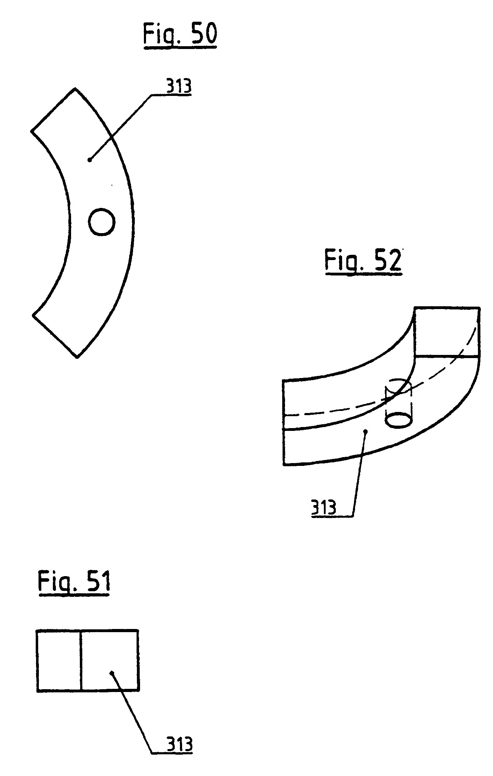

- Figur 49:: Die Klemmschraube in perspektivischer Darstellung.
- Figuren 50 und 51:: Zwei Ansichten des Kontaktstückes.
- Figur 52:: Das Kontaktstück in perspektivischer Darstellung.

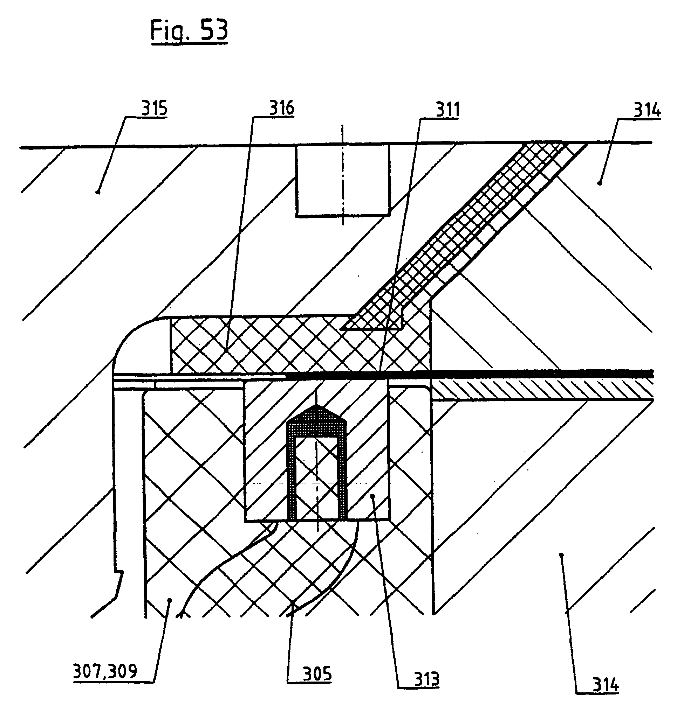

- Figur 53:: Ein Detail der Stromdurchführung.

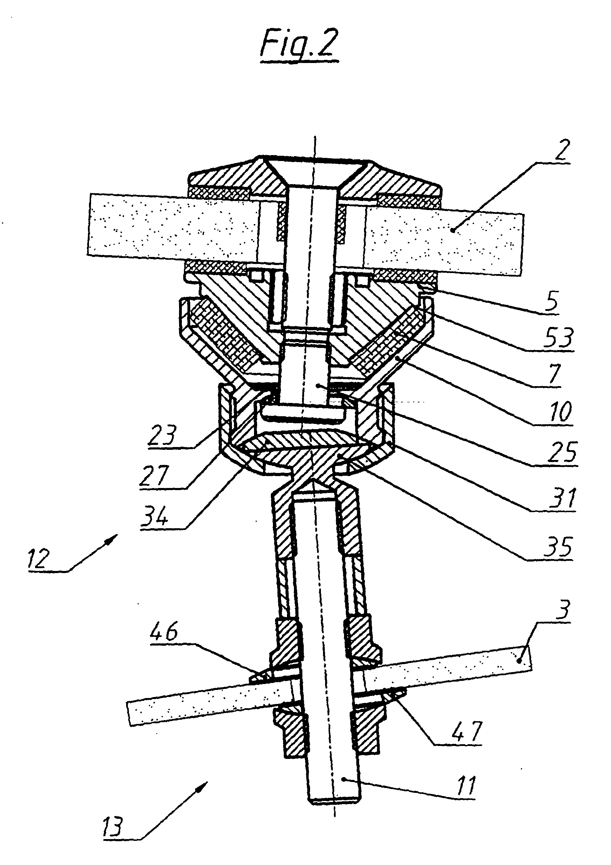

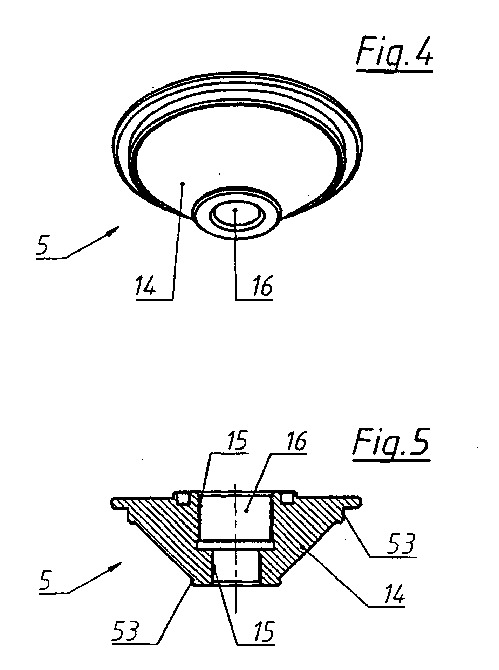

Eine Befestigungsvorrichtung 1 gemäß Figur 1 besitzt zwei Klemmelemente 4 und 5, zwischen denen eine Glasplatte 2 eingespannt ist. Der in bekannter Weise angeordnete und aus der Zeichnung ersichtliche Glasschutz ist nicht näher bezeichnet. Das innenseitige Klemmelement 5 besitzt im Ausführungsbeispiel eine kegelige Mantelfläche 14, an der ein sich an einem Vorsprung 53 abstützendes als dauerelastisches Kissen 19 ausgebildetes dauerelastisches Federglied anliegt, das praktisch damit die eigentliche Mantelfläche 6 des Klemmelementes 5 bildet. An dieser Mantelfläche 6 liegt ein Innenmantel 9 einer Überwurfglocke 10 mit einer Komplementärfläche 8 an. Eine Klemmschraube 17 durchfasst eine Durchgangsbohrung 16 (siehe Figuren 4 und 5) des Klemmelementes 5 und verbindet die beiden Klemmelemente 4 und 5. Die Durchgangsbohrung 16 weist zu diesem Zweck ein Innengewinde 15 auf. In das gleiche Innengewinde 15 fasst eine Überwurfglocken-Einstellschraube 18 ein, deren Schraubenkopf 24 sich an einem Flansch 23 eines zylindrischen Fortsatzes 21 der Überwurfglocke 10 abstützt. Zwischen dem Flansch 23 und dem Schraubenkopf 24 ist eine vorzugsweise elastische Linse 27 vorgesehen, welche sich an einer Anlagefläche 28 des Flansches 23 abstützt, so dass an dieser Stelle ein Raumgelenk im Rahmen eines Spieles 26, wie aus Figur 2 ersichtlich, gebildet wird. Die Linse 27 besitzt hierzu eine Komplementärfläche 29. Der vom Bereich des Bodentiefsten 22 ausgehende zylindrische Fortsatz 21 der Überwurfglocke 10 weist eine gegen die Halterung 3 gerichtete Stimfläche 30 auf, die konkav gekrümmt ist. Eine entsprechende gegensinnige Krümmung besitzt eine innere Topfbodenfläche 32 einer Überwurfmutter 31, so dass zwischen der Stirnfläche 30 des Fortsatzes 21 und einem Topfboden 39 der Überwurfmutter 31 zwei Linsen 34 und 35 angeordnet werden können, deren Planflächen 33 aufeinander liegen und von denen eine lose Linse 34 mit ihrer konvexen Fläche an der Stirnfläche 30 des Fortsatzes 21 anliegt, während die zweite Linse 35 fester Bestandteil einer eine Befestigungsschraube 11 aufnehmenden Mutter 36 ist und sich mit ihrer konvexen Fläche am Topfboden 39 abstützt. Die Mutter 36 besitzt einen Schaft 37, welcher eine Bohrung 38 in der Überwurfmutter 31 mit Spiel 40 durchfasst.

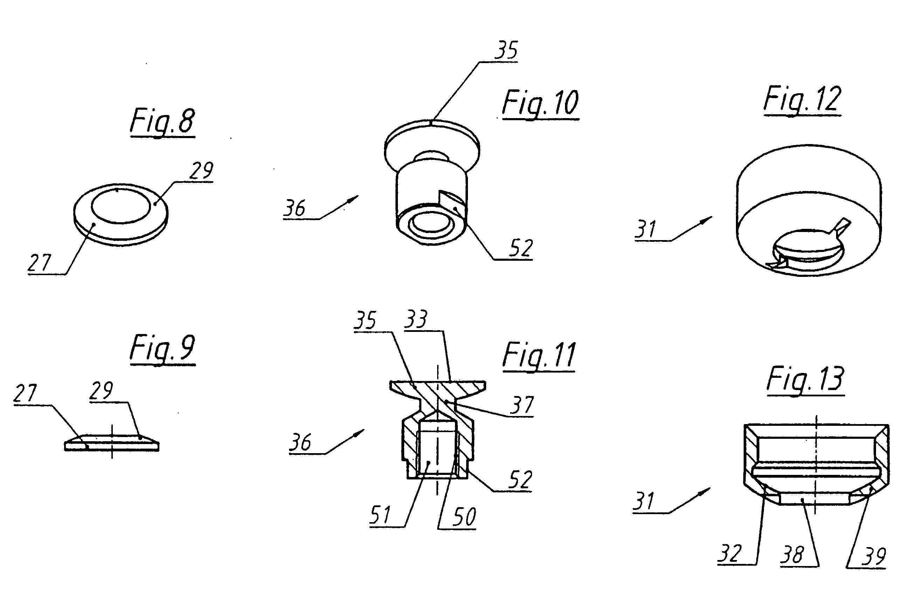

Figur 1 lässt erkennen, dass beim Aufschrauben der Überwurfmutter 31 auf die Überwurfglocke 10 mittels eines Außengewindes 20 im Bereich des Fortsatzes 21 ein allgemein mit 12 bezeichnetes und durch die beiden Linsen 34 und 35 gebildete Raumgelenk verstarrt werden kann. Die Mutter 36 (siehe Figuren 10 und 11) besitzt eine Sackbohrung 51 mit einem Innengewinde 50, in das die Befestigungsschraube 11 eingeschraubt werden kann, wobei am Außenmantel der Mutter 36 Schlüsselflächen 52 vorgesehen sind. Figur 1 zeigt ferner, dass sich im Ausführungsbeispiel an die Mutter 36 eine Distanzhülse 49 anschließt, die sich ihrerseits gegen eine die Halterung 3 einspannende Mutter 43 abstützt. Zwischen der Mutter 43 und einer Kontermutter 44 sind Linsen 46 und 47 vorgesehen, die an komplementären Anlageflächen 48 der Mutter 43 bzw. Kontermutter 44 anliegen. Planflächen 45 der Linsen 46 und 47 liegen unmittelbar an der Halterung 3 an. Da eine Befestigungsschraube 11 eine Bohrung 41 der Halterung 3 mit Spiel 42 durchfasst, ist auch hier ein mit 13 bezeichnetes Raumgelenk gebildet, mit dem Bautoleranzen ausgeglichen werden können.

Figur 2 zeigt die mögliche Schräglage der Glasplatte 2 gegenüber der Halterung 3 bei entsprechender Einstellung der Raumgelenke 12 und 13 sowie entsprechender Abwinkelung im Bereich eines Schaftes 25 der Überwurfglocken-Einstellschraube 18 gegenüber der Überwurfglocke 10 einerseits und gegenüber der Überwurfmutter 31 andererseits. Es ist ersichtlich, dass eine Verschiebung der Überwurfglocke 10 gegenüber einem dauerelastischen Federglied 7 stattgefunden hat. D. h., dass an dieser Stelle ein nicht verstarrbares Raumgelenk gebildet ist. Das dauerelastische Federglied 7 hat sich in seiner Lage relativ zum Klemmelement 5 in Folge der Abstützung an den Vorsprüngen 53 nicht verändert.

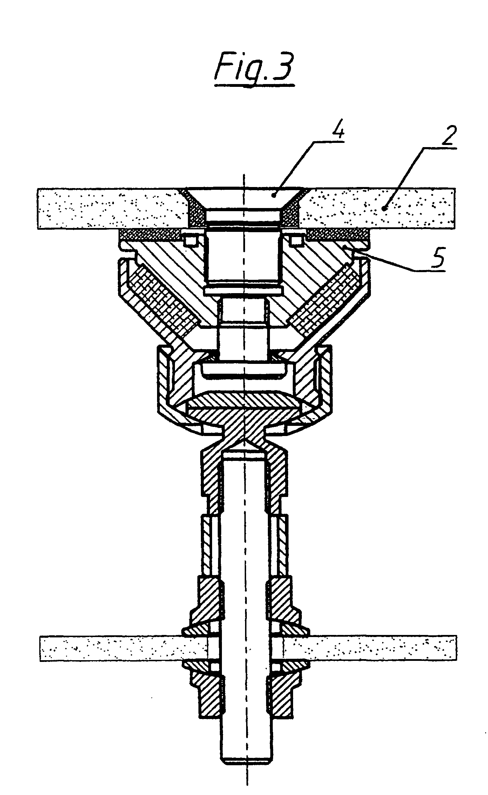

Das Ausführungsbeispiel nach Figur 3 entspricht in seinen wesentlichen Bauteilen dem Ausführungsbeispiel nach Figur 1, wobei im Gegensatz zu Figur 1 das außenseitige Klemmelement 4 als Senkschraube ausgebildet ist.

Die axiale Durchbrechung ist schlitzförmig ausgebildet, so dass in dieser schlitzförmigen Ausnehmung ein gabelartiger Abschnitt des Isolierkorbes drehfest gelagert werden kann. Ein weiterer ringförmiger Abschnitt des Isolierkorbes ist in einer lochartigen Aussparung der Glasscheibe gehalten und weist gegen die Leitungen der voltaischen gerichteten Elemente gerichtete Nuten auf, in denen - vorzugsweise federbelastet - mit den Leitungen eines flexiblen Schlauches verbundene Kontaktstücke gelagert sind.

Die Einspannung des Isolierkorbes erfolgt zwischen einer die Glasscheibe einspannenden Klemmschraube und dem gebäudeinnenseitigen Klemmelement, wobei zwischen der Klemmschraube und den Kontaktstücken bzw. der Leitungen der voltaischen Elemente ein Isolierring vorgesehen ist. Der flexible Schlauch ist in der bereits beschriebenen Weise durch das gebäudeinnenseitige Klemmelement und die Pendelmutter hindurchgeführt, wobei vorzugsweise im Bereich der gebäudeseitigen Halterung ein weiteres verstarrbares Raumgelenk, durch das der flexible Schlauch hindurchgeführt ist, vorgesehen ist.

Erfindungsgemäße Glasscheiben 101 werden im Allgemeinen als Glasfassade über Stützstreben an einer Gebäudefront befestigt.

Die erfindungsgemäße Glasscheibe 101 besteht im gezeigten Ausführungsbeispiel aus zwei miteinander verklebten Einzelscheiben 102, 103, zwischen denen sich mehrere voltaische Elemente 104 befinden. Die voltaischen Elemente 104 sind mit Leitungen versehen bzw. verbunden, mittels denen der Strom aus den voltaischen Elementen 104 abgeleitet wird. Die Leitungen werden im Ausführungsbeispiel von flachen Metallstreifen 105 gebildet.

Die Glasscheibe 101 ist mit mehreren lochförmigen Aussparungen 106 versehen, in deren Bereich die Befestigungsvorrichtung 107 angeordnet ist. Die Befestigungsvorrichtung 107 besteht aus einem inneren, d. h. der Glasscheibe zugewandten Halterungsteller 108 und einem gegenüberliegenden äußeren Halterungsteller 109. Die Halterungsteller 108, 109 sind im Ausführungsbeispiel mittels dreier separater Schrauben 110 verschraubt. Die Schrauben 110 sind in Muttergewinden 111 im Halterungsteller 108 gehalten und ragen durch Löcher im Halterungsteller 109.

Beide Halterungsteller 108, 109 sind mit zylindrischen Ansätzen 113, 114 versehen, die in die Aussparung 106 der Glasscheibe 101 ragen und in deren Bereich die Schrauben 110 angeordnet sind.

Zwischen der Glasscheibe 101 und dem Halterungsteller 108, 109 sind separate Dichtungen 115, beispielsweise aus Gummi oder Kunststoff, eingelegt.

Der äußere Halterungsteller 109 weist eine mittige Öffnung 117 auf. Die Öffnung 117 ist mit einem Muttergewinde versehen, in das ein Gegengewinde eines an der Abdeckkappe 116 ausgebildeten bolzenartigen Vorsprunges 118 eingreift.

Bei der Montage der Glasscheibe 101 können die beiden Halterungsteller 108, 109 fixiert und zusammen mit der Glasscheibe 101 mittels einer Befestigungsschraube 120 an einem Traggerüst oder dergleichen montiert werden. Anschließend werden Metallstreifen 105 und Kabel 124, die zusammen mit Leitungen die Ableitung von Strom bilden, durch Kupplungen 125 verbunden. Vorzugsweise sind die Kupplungen 125 als Steckkupplungen ausgebildet. Es kann sich jedoch auch um eine Schweißverbindung handeln.

Im Ausführungsbeispiel nach der Figur 16 ist ein innerer, d. h. der dem Gebäude zugekehrte Halterungsteller 108 mit einem Langloch versehen, durch das die Befestigungsschraube 120 ragt. Die Befestigungsschraube 120 weist einen Kopfteil 121 auf, der sich an einer Haltefläche 122 des Halterungstellers 108 abstützt und diesen klemmend hält. Im Kopfteil 121 ist ein Innensechskant 127 oder dergleichen ausgebildet, über den die Befestigungsschraube 120 gedreht werden kann. Der Halterungsteller 108 ist in Bezug auf die Befestigungsschraube 120 über die Länge eines Langloches 119 verschiebbar, wodurch Montagedifferenzen ausgeglichen werden können.

Die Befestigungsschraube 120 ist als Hohlzylinder ausgebildet und mit einer axial durchgehenden Öffnung 123 versehen, durch die Kabel 124 ragen, die innerhalb der Aussparung 106 über Kupplungen 125 an die Leitungen 105 angeschlossen sind und zusammen mit diesen die Leitungen für die Ableitung von Strom aus den voltaischen Elementen 104 bilden.

Im Ausführungsbeispiel nach der Figur 20 ist die Befestigungsschraube 120 in ein Muttergewinde 126 im Halterungsteller 108 eingeschraubt. Die Befestigungsschraube 120 weist in diesem Ausführungsbeispiel am hinteren Ende einen Innensechskant 127 oder dergleichen auf, der den Angriff eines Inbusschlüssels ermöglicht.

Um eine Oxidation der von den Metallstreifen und den Kabeln 124 gebildeten Leitungen für die Ableitung von Strom im Bereich der Kupplungen 125 zu vermeiden, sind die Aussparungen 106 vorzugsweise mit einem Material geringer elektrischer Leitfähigkeit, beispielsweise Wachs oder einem Kunststoffmaterial wie Polyurethan, ausgefüllt.

Die Leitungen für die Ableitung von Strom treten bei den Befestigungsbeschlägen 107 zwischen den Halterungstellern 108, 109 radial ein und durch den inneren Halterungsteller 108 und die Befestigungsschraube 120 axial aus. Es gibt daher keine optisch störenden Anschlüsse, femer sind die Anschlüsse gegen Beschädigungen geschützt.

Im Ausführungsbeispiel nach den Figuren 23 bis 36 weist eine eine Glasplatte 202 einspannende Befestigungsvorrichtung 201 eine mit einer zentrischen Durchgangsbohrung 206 versehene Überwurfglocken-Einstellschraube 203 auf. In gleicher Weise besitzt eine Pendelschraube 205 eine Durchgangsbohrung 206. Die Überwurfglocken-Einstellschraube verspannt in der in der Figur 1 beschriebenen Weise ein gebäudeinnenseitiges Klemmelement 214 mit einer Überwurfglocke 222. Die zentrische Durchgangsbohrung 206 wird z. B. von einem Schrumpfschlauch 208 bzw. Isolierschlauch durchfasst, welcher in der Bildebene (siehe Figur 25) im oberen Bereich an einen Isolator 210 anschließt. Die im Schrumpfschlauch 208 verlaufenden Leitungen 207 sind bis in den Isolator 210 durchgeführt und dort über Klemmen 219 an Kontaktstücken 218 an Leitungen 211 der voltaischen Elemente 212 angeschlossen. Der Isolator 210 ist in einer Iochförmigen Aussparung 209 der Glasplatte 202 angeordnet und mittels Klemmschrauben 215, welche Durchgangsbohrungen 213 in dem Isolator 210 durchfassen und in das gebäudeinnenseitige Klemmelement 214 einfassen, zwischen dem Klemmelement 214 und einer Kegelmutter 221 festgelegt. Der Isolator 210 selbst weist radiale Schlitzausnehmungen 216 und axiale Führungskanäle 217 auf, wobei in den radialen Schlitzausnehmungen 216 Kontaktstücke 218 angeordnet sind, deren Schenkel 220 zur Anlage und damit Kontaktierung mit den Leitungen 211 der voltaischen Elemente 212 gelangen.

Im Ausführungsbeispiel nach den Figuren 37 bis 53 weist eine eine Glasplatte 314 einspannende Befestigungsvorrichtung 301 ein gebäudeinnenseitiges Klemmelement 302 auf, welches mit einer axialen Durchbrechung 303 versehen ist, in die zentrisch mittels eines Gewindes 318 eine Klemmschraube 315 einfasst. Die axiale Durchbrechung ist schlitzförmig ausgestaltet und dient der drehfesten Aufnahme eines gabelförmigen Abschnittes 310 eines Isolierkorbes 307, der mit seinem über das Klemmelement 302 nach außen vorstehenden ringförmigen Abschnitt 309 in einer Aussparung 308 der Glasscheibe 314 gelagert ist. Der Isolierkorb weist gegen Leitungen 311 der voltaischen Elemente 304 gerichtete Nuten 312 auf, in denen - vorzugsweise federbelastet - ringförmige Kontaktstücke 313 gelagert sind, über die der elektrische Kontakt zwischen den Leitungen 311 der voltaischen Elemente 304 und den Leitungen 305 eines Schrumpfschlauches 306 hergestellt wird. Zwischen einer Klemmschraube 315 und den Kontaktstücken 313 bzw. den Leitungen 311 der voltaischen Elemente 304 ist ein Isolierring 316 vorgesehen. Der Schrumpfschlauch 306 ist über einen zapfenartigen Ansatz 317 eines Isolierkorbes 307 lösbar mit diesem verbunden.

Die vorbeschriebene Befestigungsvorrichtung 301 ist somit geeignet, die Elastizität der Glasplatten 2, 314 zu erhalten, da sie die Bewegungsfreiheit dieser nicht einschränkt und somit zu einer Kraftneutralisierung führt. Die erfindungsgemäße Befestigungsvorrichtung bedeutet Anpassung an die Umgebungsvorgaben und nicht eine Rigidität des Baustoffes Glas, die zwangsläufig zu einer Zerstörung führt, wie es beim aufgezeigten Stand der Technik der Fall ist. Ferner ist eine optimale Ableitung des gewonnen Stromes unter Verzicht auf separate Durchführungsanlagen möglich.

Für jegliche Anwendungen von punktförmig aufgehängten Glasplatten, ob innen oder außen, ob mit oder ohne voltaischen Elementen, eignet sich die Befestigungsvorrichtung zur spannungsfreien Montage und auch zum spannungsfreien Dauerbetrieb.

### Bezugszeichenliste

- 1: Befestigungsvorrichtung
- 2: Glasplatte
- 3: gebäudeseitige Halterung
- 4: innenseitiges Klemmelement
- 5: außenseitiges Klemmelement
- 6: erste Mantelfläche
- 7: dauerelastisches Federglied
- 8: Komplementärfläche
- 9: Innenmantel
- 10: Überwurfglocke
- 11: Befestigungsschraube
- 12: erstes verstarrbares Raumgelenk
- 13: zweites verstarrbares Raumgelenk
- 14: zweite Mantelfläche
- 15: Innengewinde
- 16: Durchgangsbohrung
- 17: Klemmschraube
- 18: Überwurfglocken-Einstellschraube
- 19: dauerelastisches Kissen
- 20: Außengewinde
- 21: zylindrischer Fortsatz
- 22: Bodentiefstes
- 23: Flansch
- 24: Schraubenkopf
- 25: Schaft
- 26: Spiel
- 27: Linse
- 28: Anlagefläche
- 29: Komplementärfläche
- 30: Stirnfläche
- 31: Überwurfmutter
- 32: innere Topfbodenfläche
- 33: Planfläche
- 34: erste Linse
- 35: erste Linse
- 36: erste Mutter
- 37: Schaft
- 38: Bohrung
- 39: Topfboden
- 40: Spiel
- 41: Bohrung
- 42: Spiel
- 43: zweite Mutter
- 44: Kontermutter
- 45: Planflächen
- 46: zweite Linse
- 47: zweite Linse
- 48: komplementäre Anlagefläche
- 49: Distanzhülse
- 50: Innengewinde
- 51: Sackbohrung
- 52: Schlüsselflächen
- 53: Vorsprung
- 101: Glasscheibe
- 102: Einzelscheibe
- 103: Einzelscheibe
- 104: voltaische Elemente
- 105: Metallstreifen
- 106: lochförmige Aussparung
- 107: Befestigungsvorrichtung
- 108: Halterungsteller
- 109: Halterungsteller
- 110: Schrauben
- 111: Muttergewinde
- 112: Bohrung
- 113: zylindrischer Ansatz
- 114: zylindrischer Ansatz
- 115: Dichtung
- 116: Abdeckkappe
- 117: Öffnung
- 118: Vorsprung
- 119: Langloch
- 120: Befestigungsschraube
- 121: Kopfteil
- 122: Haltefläche
- 123: Öffnung
- 124: Kabel
- 125: Kupplung
- 126: Muttergewinde
- 127: Innensechskant
- 201: Befestigungsvorrichtung
- 202: Glasplatte
- 203: Überwurfglocken-Einstellschraube
- 204: Überwurfmutter
- 205: Pendelschraube
- 206: zentrische Durchgangsbohrung
- 207: Leitung
- 208: Schrumpfschlauch/flexibler Schlauch
- 209: lochförmige Aussparung
- 210: Isolator
- 211: Leitung
- 212: voltaische Elemente
- 213: Durchgangsbohrungen
- 214: gebäudeinnenseitiges Klemmelement
- 215: Klemmschrauben
- 216: radiale Schlitzöffnung
- 217: axiale Führungskanäle
- 218: Kontaktstück
- 219: Klemmen
- 220: Schenkel
- 221: Überwurfglocke
- 222: Überwurfglocke
- 301: Befestigungsvorrichtung
- 302: gebäudeinnenseitiges Klemmelement
- 303: axiale Durchbrechung
- 304: voltaische Elemente
- 305: Leitungen des Schrumpfschlauches
- 306: Schrumpfschlauch
- 307: Isolierkorb
- 308: Aussparung
- 309: ringförmiger Abschnitt
- 310: gabelartiger Abschnitt
- 311: Leitung
- 312: Nuten
- 313: Kontaktstücke
- 314: Glasscheibe
- 315: Klemmschraube
- 316: Isolierung
- 317: zapfenförmiger Ansatz
- 318: Gewinde

## Patentansprüche

1. Befestigungsvorrichtung für ein mindestens einflächiges voltaisches, eine Glasplatte (2) aufweisendes Element an einer gebäudeseitigen Halterung (3) mit einem außenseitigen (4) und einem innenseitigen (5), die Glasplatte (2) im Einbauzustand zwischen sich einspannenden Klemmelement und mit einer Abstützung der Befestigungsvorrichtung an dem innenseitigen Klemmelement (5), wobei das innenseitige Klemmelement (5) an seiner im Einbauzustand der Glasplatte (2, 101, 202, 314) abgewandten ersten Mantelfläche (6) eine durch ein dauerelastisches Federglied (7) gebildete kegelige oder ballige Mantelfläche (6) aufweist, gegen die eine erste Komplementärfläche (8) eines Innenmantels (9) einer Überwurfglocke (10) mit einstellbarer Vorspannung anstellbar ist, und wobei zwischen der Überwurfglocke (10) und einer Befestigungsschraube (11) ein erstes verstarrbares Raumgelenk (12) angeordnet ist, **dadurch gekennzeichnet, dass** zwischen der Befestigungsschraube (11) und der Halterung (3) zusätzlich ein zweites verstarrbares Raumgelenk (13) angeordnet ist, und dass Leitungen für die Ableitung von Strom durch die Befestigungsvorrichtung (1, 107, 201, 301) durchführbar sind.

2. Befestigungsvorrichtung nach Anspruch 1, **dadurch gekennzeichnet, dass** das innenseitige Klemmelement (5) an seiner der Glasplatte (2) abgewandten zweiten Mantelfläche (14) eine kegelige oder ballige Mantelfläche (14) aufweist.

3. Befestigungsvorrichtung nach Anspruch 1 und 2, **dadurch gekennzeichnet, dass** das innenseitige Klemmelement (5) eine ein Innengewinde (15) aufweisende zentrische Durchgangsbohrung (16) für die Aufnahme einer die Klemmelemente (4, 5) verbindenden Klemmschraube (17) und einer die Überwurfglocke (10) mit dem innenseitigen Klemmelement (5) verbindende Überwurfglocken-Einstellschraube (18) aufweist.

4. Befestigungsvorrichtung nach Anspruch 1 und 2, **dadurch gekennzeichnet, dass** zwischen der der Glasplatte (2) im Einbauzustand abgewandten kegeligen oder balligen Fläche des innenseitigen Klemmelementes (5) und der Komplementärfläche (8) der Überwurfglocke (10) ein dauerelastisches Kissen (9) angeordnet ist.

5. Befestigungsvorrichtung nach einem der Ansprüche 1 bis 4, **dadurch gekennzeichnet, dass** die Überwurfglocke (10) an ihrer der Halterung (3) im Einbauzustand zugewandten Seite einen mit einem Außengewinde (20) versehenen zylindrischen Fortsatz (21) aufweist, zwischen dem und der Überwurfglocke (10) im Bereich des Bodentiefsten (22) der Überwurfglocke (10) ein nach innen gerichteter Flansch (23) für die Abstützung des Schraubenkopfes (24) der Überwurfglocken-Einstellschraube (18) ausgebildet ist.

6. Befestigungsvorrichtung nach Anspruch 5, **dadurch gekennzeichnet, dass** zwischen dem Flansch (23) und einem Schaft (25) der Überwurfglocken-Einstellschraube ein Spiel (26) vorgesehen ist.

7. Befestigungsvorrichtung nach Anspruch 5 und 6, **dadurch gekennzeichnet, dass** zwischen dem Flansch (23) und dem Schraubenkopf (24) der Überwurfglocken-Einstellschraube (18) eine Linse (27) angeordnet ist.

8. Befestigungsvorrichtung nach Anspruch 5 bis 7, **dadurch gekennzeichnet, dass** eine Anlagefläche (28) des Flansches (23) und eine zweite Komplementärfläche (29) der Linse (27) kegelig oder ballig verlaufend ausgebildet sind.

9. Befestigungsvorrichtung nach Anspruch 5, **dadurch gekennzeichnet, dass** eine im Einbauzustand gegen die Halterung (3) gerichtete Stirnfläche (30) des Fortsatzes (21) der Überwurfglocke (10) konkav linsenförmig gekrümmt ist.

10. Befestigungsvorrichtung nach einem der Ansprüche 5 bis 9, **gekennzeichnet durch** eine das Außengewinde (20) des Fortsatzes (21) der Überwurfglocke (10) überfassende topfartige Überwurfmutter (31), deren innere Topfbodenfläche (32) gegensinnig zur Stirnfläche (30) des Fortsatzes (21) der Überwurfglocke (10) gekrümmt ist.

11. Befestigungsvorrichtung nach Anspruch 10, **dadurch gekennzeichnet, dass** zwischen der Stirnfläche (30) des Fortsatzes (21) der Überwurfglocke (10) und der Topfbodenfläche (32) der Überwurfmutter (31) zwei mit ihren Planflächen (33) aneinander liegende, plankonvexe erste Linsen (34, 35) angeordnet sind.

12. Befestigungsvorrichtung nach Anspruch 11, **dadurch gekennzeichnet, dass** die der Topfbodenfläche (32) der Überwurfmutter (31) anliegende plankonvexe erste Linse (35) Bestandteil einer die Befestigungsschraube (11) aufnehmenden ersten Mutter (36) ist.

13. Befestigungsvorrichtung nach Anspruch 12, **dadurch gekennzeichnet, dass** ein Schaft (37) der ersten Mutter (36) eine Bohrung (38) im Topfboden (39) der Überwurfmutter (31) mit Spiel durchfasst.

14. Befestigungsvorrichtung nach einem der Ansprüche 1 bis 13, **dadurch gekennzeichnet, dass** die Befestigungsschraube (11) im Einbauzustand eine Bohrung (41) in der Halterung (3) mit Spiel (42) durchfasst und die Halterung (3) im Einbauzustand zwischen einer zweiten Mutter (43) und einer Kontermutter (44) festgelegt ist, wobei zwischen der zweiten Mutter (43) bzw. der Kontermutter (44) einerseits und der Halterung (3) andererseits jeweils eine plankonvexe, mit ihrer Planfläche (45) der Halterung anliegende zweite Linse (46, 47) vorgesehen ist und die zweite Mutter (43) und Kontermutter (44) zur Linse (46, 47) eine komplementäre Anlagefläche (48) aufweisen.

15. Befestigungsvorrichtung nach einem der Ansprüche 1 bis 14, **dadurch gekennzeichnet, dass** im Einbauzustand zwischen der die Befestigungsschraube (11) aufnehmenden ersten Mutter (36) und der die Halterung (3) festlegende zweite Mutter (43) eine Distanzhülse (49) angeordnet ist.

16. Befestigungsvorrichtung nach einem der Ansprüche 1 bis 15, **dadurch gekennzeichnet, dass** das außenseitige Klemmelement (4) als Klemmteller ausgebildet ist.

17. Befestigungsvorrichtung nach einem der Ansprüche 1 bis 15, **dadurch gekennzeichnet, dass** das außenseitige Klemmelement (4) als Senkschraube ausgebildet ist.

18. Befestigungsvorrichtung nach einem der Ansprüche 1 bis 18, **dadurch gekennzeichnet, dass** die Befestigungsvorrichtung (107) zwei miteinander kuppelbare - vorzugsweise verschraubbare - Halterungsteller (108, 109) umfasst, zwischen denen die Glasscheibe (101) im Einbauzustand gehalten ist, wobei die Leitungen für die Ableitung von Strom radial zwischen den Halterungstellern (108, 109) eintreten und axial bei einem der Halterungsteller (108) austreten.

19. Befestigungsvorrichtung nach Anspruch 18, **dadurch gekennzeichnet, dass** jeder Halterungsteller (108, 109) einen zylindrischen Ansatz (113, 114) aufweist, der im Einbauzustand in eine Aussparung (106) der Glasscheibe (101) ragt.

20. Befestigungsvorrichtung nach einem der Ansprüche 18 oder 19, **dadurch gekennzeichnet, dass** die Halterungsteller (108, 109) mittels separater Schrauben (110), die vorzugsweise im Bereich der zylindrischen Ansätze (113, 114) angeordnet sind, verschraubt sind.

21. Befestigungsvorrichtung nach einem der Ansprüche 1 bis 21, **dadurch gekennzeichnet, dass** die Leitungen für die Ableitung von Strom im Bereich der Halterungsteller (108, 109) Kupplungen (125) aufweisen.

22. Befestigungsvorrichtung nach einem der Ansprüche 18 bis 21, **dadurch gekennzeichnet, dass** einer der Halterungsteller (108) von einer Befestigungsschraube (120) gehalten wird, die als Hohlzylinder ausgeführt ist und durch die die Kabel (124) der Leitungen für die Ableitung von Strom aus den voltaischen Elementen (104) geführt sind.

23. Befestigungsvorrichtung nach Anspruch 22, **dadurch gekennzeichnet, dass** die Befestigungsschraube (120) den Halterungsteller (108) klemmend hält.

24. Befestigungsvorrichtung nach Anspruch 23, **dadurch gekennzeichnet, dass** die Befestigungsschraube (120) durch einen Längsschlitz (119) des Halterungstellers (108) ragt.

25. Befestigungsvorrichtung nach einem der Ansprüche 18 bis 24, **dadurch gekennzeichnet, dass** einer der Halterungsteller (109) eine axiale Öffnung (117) aufweist, die von einer Kappe (116) abgedeckt wird.

26. Befestigungsvorrichtung nach Anspruch 25, **dadurch gekennzeichnet, dass** die Öffnung (117) mit einem Muttergewinde versehen ist, in das ein bolzenartiger Vorsprung (118) der Kappe (116) einschraubbar ist.

27. Befestigungsvorrichtung nach einem der Ansprüche 24 bis 26, **dadurch gekennzeichnet, dass** die Befestigungsschraube (120) mit einem Innensechskant (127) versehen ist.

28. Befestigungsvorrichtung nach einem der Ansprüche 22 bis 27, **dadurch gekennzeichnet, dass** eine Überwurfglocken-Einstellschraube (203) und eine von einer Überwurfmutter (204) eingespannte, mit der Befestigungsschraube (120) verbindbare Pendelschraube (205) eine zentrische Durchgangsbohrung (206) für die Aufnahme eines flexiblen Schlauches (208) aufweisen.

## Claims

1. An attachment device for a voltaic cell having at least one face and presenting a glass pane (2), at a mounting (3) on the building side with an outside (4) and an inside (5) clamping element fastening the glass pane (2) in the installed condition between them and having a support of the attachment device at the inside clamping element (5), the inside clamping element (5), on its first envelope surface (6) opposite to the glass pane (2, 101, 202, 314) in the installed condition, presenting a conical or crowned envelope surface (6) formed by a permanently elastic spring member (7), against which surface a first complementary surface (8) of an interior envelope (9) of a coupling bell (10) is adjustable with an adaptable initial tension, and a first three-dimensional articulation (12), which is able to be stiffened, being disposed between the coupling bell (10) and an attachment bolt (11), **characterised in that** additionally a second three-dimensional articulation (13), which is able to be stiffened, is disposed between the attachment bolt (11) and the mounting (3), and **in that** wires conducting the current may pass through the attachment device (1, 107, 201, 301).

2. An attachment device according to claim 1, **characterised in that** the inside clamping element (5), on the second envelope surface (14) thereof opposite to the glass pane (2), presents a conical or crowned envelope surface (14).

3. An attachment device according to claim 1 and 2, **characterised in that** the inside clamping element (5) presents a centrical through borehole (16) having a female thread (15) for the accommodation of a clamp screw (17) connecting the clamping elements (4, 5) and a coupling bell regulating screw (18) connecting the coupling bell (10) to the inside clamping element (5).

4. An attachment device according to claim 1 and 2, **characterised in that** a permanently elastic cushion (9) is disposed between the conical or crowned surface of the inside clamping element (5), surface opposite to the glass pane (2) in the installed condition, and the complementary surface (8) of the coupling bell (10).

5. An attachment device according to one of the claims 1 to 4, **characterised in that** the coupling bell (10) on the side thereof oriented towards the mounting (3) in the installed condition presents a cylindrical extension (21) provided with a male thread (20), between said extension and the coupling bell (10) in the area of the coupling bell's (10) bottom (22) is formed an inwardly oriented flange (23) to support the screw head (24) of the coupling bell regulating screw (18).

6. An attachment device according to claim 5, **characterised in that** a play (26) is provided between the flange (23) and a shaft (25) of the coupling bell regulating screw.

7. An attachment device according to claim 5 and 6, **characterised in that** a lens (27) is disposed between the flange (23) and the screw head (24) of the coupling bell regulating screw (18).

8. An attachment device according to claim 5 to 7, **characterised in that** a locating face (28) of the flange (23) and a second complementary surface (29) of the lens (27) is formed in a conical or crowned extending shape.

9. An attachment device according to claim 5, **characterised in that**, in the installed condition, a front surface (30) of the extension (21) of the coupling bell (10) oriented towards the mounting (3) is curved in a concave lenticular shape.

10. An attachment device according to one of the claims 5 to 9, **characterised in that** a pot-like union nut (31) overlapping the male thread (20) of the extension (21) of the coupling bell (10) has an inner pot bottom surface (32), which is curved in the opposite direction with regard to the front surface (30) of the extension (21) of the coupling bell (10).

11. An attachment device according to claim 10, **characterised in that** between the front surface (30) of the extension (21) of the coupling bell (10) and the pot bottom surface (32) of the union nut (31) are disposed two plano-convex first lenses (34, 35) abutting with the flat surfaces (33) thereof.

12. An attachment device according to claim 11, **characterised in that** the plano-convex first lens (35) abutting at the pot bottom surface (32) of the union nut (31) forms a component of a first nut (36) accommodating the attachment bolt (11).

13. An attachment device according to claim 12, **characterised in that** a shaft (37) of the first nut (36) passes with play through a borehole (38) in the pot bottom (39) of the union nut (31).

14. An attachment device according to one of the claims 1 to 13, **characterised in that** in the installed condition the attachment bolt (11) passes with play (42) through a borehole (41) in the mounting (3) and the mounting (3), is secured between a second nut (43) and a counter nut (44), on the one hand between the second nut (43) respectively the counter nut (44) and on the other hand the mounting (3) respectively one plano-convex second lens (46, 47) being provided, which with the flat surface (45) thereof abuts at the mounting, and the second nut (43) and the counter nut (44) are designed to present a complementary locating face (48) with regard to the lens (46, 47).

15. An attachment device according to one of the claims 1 to 14, **characterised in that**, in the installed condition, a distance sleeve (49) is disposed between the first nut (36) accommodating the attachment bolt (11) and the second nut (43) securing the mounting (3).

16. An attachment device according to one of the claims 1 to 15, **characterised in that** the outside clamping element (4) is designed as a clamping disc.

17. An attachment device according to one of the claims 1 to 15, **characterised in that** the outside clamping element (4) is designed as a countersunk screw.

18. An attachment device according to one of the claims 1 to 17, **characterised in that** the attachment device (107) includes two holding discs (108, 109) that can be coupled to each other - preferably screwed -, maintaining between them the glass pane (101) in the installed condition, the wires conducting the current radially entering between the holding discs (108, 109) and axially exiting at one of the holding discs (108).

19. An attachment device according to claim 18, **characterised in that** each holding disc (108, 109) presents a cylindrical extension (113, 114), which, in the installed condition, protrudes as far as into an aperture (106) of the glass pane (101).

20. An attachment device according to one of the claims 18 or 19, **characterised in that** the holding discs (108, 109) are screwed by means of separate bolts (110), which are preferably disposed in the region of the cylindrical extensions (113, 114).

21. An attachment device according to one of the claims 1 to 20, **characterised in that** the wires conducting the current present couplings (125) in the region of the holding discs (108, 109).

22. An attachment device according to one of the claims 18 to 21, **characterised in that** one of the holding discs (108) is maintained by an attachment bolt (120) executed as a hollow cylinder and through which pass the cables (124) of the wires conducting the current from the voltaic cells (104).

23. An attachment device according to claim 22, **characterised in that** the attachment bolt (120) holds the holding disc (108) in a clamping manner.

24. An attachment device according to claim 23, **characterised in that** the attachment bolt (120) protrudes through an oblong slot (119) of the holding disc (108).

25. An attachment device according to one of the claims 18 to 24, **characterised in that** one of the holding discs (109) presents an axial opening (117), which is covered by a cap (116).

26. An attachment device according to claim 25, **characterised in that** the opening (117) is equipped with a female thread into which a bolt-like projection (118) of the cap (116) is screwable.

27. An attachment device according to one of the claims 24 to 26, **characterised in that** the attachment bolt (120) is provided with a hexagon socket (127).

28. An attachment device according to one of the claims 22 to 27, **characterised in that** a coupling bell regulating screw (203) and a floating screw (205), which is clamped by a union nut (204) and can be connected to the attachment bolt (120), present a central through borehole (206) for the accommodation of a flexible tube (208).

## Revendications

1. Dispositif de fixation pour un panneau voltaïque présentant au moins une surface, comprenant une vitre en verre (2), sur un support (3) côté bâtiment avec un membre de serrage extérieur (4) et un membre de serrage intérieur (5) serrant entre-eux la vitre en verre (2) en état monté et avec un élément d'appui pour le dispositif de fixation sur le membre de serrage intérieur (5), le membre de serrage intérieur (5) présentant, sur sa première surface d'enveloppe (6) opposée à la vitre en verre (2, 101, 202, 314) en état monté, une surface d'enveloppe (6) conique ou sphérique formée par l'intermédiaire d'un membre à ressort (7) à élasticité en permanente, contre laquelle une première surface complémentaire (8) d'une enveloppe intérieur (9) d'une cloche d'accouplement (10) est ajustable avec une précontrainte réglable, et une première articulation en trois dimensions (12) que l'on peut rigidifier étant disposée entre la cloche d'accouplement (10) et une vis de fixation (11), **caractérisé en ce que** de plus une deuxième articulation en trois dimensions (13) que l'on peut rigidifier est disposée entre la vis de fixation (11) et le support (3), et **en ce que** des lignes pour la transmission de courant peuvent passer à travers le dispositif de fixation (1, 107, 201, 301).

2. Dispositif de fixation selon la revendication 1, **caractérisé en ce que** le membre de serrage intérieur (5) présente une surface d'enveloppe conique ou sphérique (14) sur sa deuxième surface d'enveloppe (14) opposée à la vitre en verre (2).

3. Dispositif de fixation selon la revendication 1 et 2, **caractérisé en ce que en ce que** le membre de serrage intérieur (5) présente un perçage central (16) ayant un taraudage (15) pour accommoder une vis de serrage (17), reliant les membres de serrage (4, 5), et une vis d'ajustement de la cloche d'accouplement (18), reliant la cloche d'accouplement (10) avec le membre de serrage intérieur (5).

4. Dispositif de fixation selon la revendication 1 et 2, **caractérisé en ce qu'**un coussin à élasticité permanente (9) est disposé entre la surface conique ou sphérique du membre de serrage intérieur (5), opposée à la vitre en verre (2) en état monté, et la surface complémentaire (8) de la cloche d'accouplement (10).

5. Dispositif de fixation selon l'une des revendications 1 à 4, **caractérisé en ce que** la cloche d'accouplement (10) présente, sur son côté orienté au support (3) en état monté, un prolongement cylindrique (21) pourvu d'un filetage mâle (20), entre ce prolongement et la cloche d'accouplement (10), dans la région la plus profonde du fond (22) de la cloche d'accouplement (10), étant formée une bride (23), orientée vers l'intérieur, pour le soutien de la tête de vis (24) de la vis d'ajustement de la cloche d'accouplement (18).

6. Dispositif de fixation selon la revendication 5, **caractérisé en ce qu'**un jeu (26) est prévu entre la bride (23) et une tige (25) de la vis d'ajustement de la cloche d'accouplement.

7. Dispositif de fixation selon la revendication 5 et 6, **caractérisé en ce qu'**une lentille (27) est disposée entre la bride (23) et la tête de vis (24) de la vis d'ajustement de la cloche d'accouplement (18).

8. Dispositif de fixation selon la revendication 5 à 7, **caractérisé en ce qu'**une surface d'appui (28) de la bride (23) et une deuxième surface complémentaire (29) de la lentille (27) sont formées de façon à s'étendre coniquement ou sphériquement.

9. Dispositif de fixation selon la revendication 5, **caractérisé en ce que**, en état monté orientée contre le support (3), une surface frontale (30) du prolongement (21) de la cloche d'accouplement (10) est courbée de façon concave lenticulaire.

10. Dispositif de fixation selon l'une des revendications 5 à 9, **caractérisé en ce qu'**un écrou d'accouplement en forme de pot (31) enveloppant le filetage mâle (20) du prolongement (21 ) de la cloche d'accouplement (10) présente une surface intérieure de fond en forme de pot (32) étant courbée en sens inverse par rapport à la surface frontale (30) du prolongement (21) de la cloche d'accouplement (10).

11. Dispositif de fixation selon la revendication 10, **caractérisé en ce que**, entre la surface frontale (30) du prolongement (21) de la cloche d'accouplement (10) et la surface du fond en forme de pot (32) de l'écrou d'accouplement (31), les surfaces planes (33) de deux premières lentilles (34, 35) plan-convexes sont disposées de façon contiguë.

12. Dispositif de fixation selon la revendication 11, **caractérisé en ce que** la première lentille (35) plan-convexe étant contiguë de la surface du fond en forme de pot (32) de l'écrou d'accouplement (31) fait partie d'un premier écrou (36) recevant la vis de fixation (11 ).

13. Dispositif de fixation selon la revendication 12, **caractérisé en ce qu'**une tige (37) du premier écrou (36) passe avec jeu à travers un perçage (38) dans le fond du pot (39) de l'écrou d'accouplement (31).

14. Dispositif de fixation selon l'une des revendications 1 à 13, **caractérisé en ce que** la vis de fixation (11) en état monté passe avec jeu (42) à travers un perçage (41) dans le support (3) et le support (3) en état monté est fixé entre un deuxième écrou (43) et un contre-écrou (44), une deuxième lentille (46, 47) plan-convexe étant prévue, entre le deuxième écrou (43) respectivement le contre-écrou (44) d'une part et le support (3) d'autre part, dont la surface plane (45) est contiguë du support, et le deuxième écrou (43) et le contre-écrou (44) présentant une surface d'appui (48) complémentaire à la lentille (46, 47).

15. Dispositif de fixation selon l'une des revendications 1 à 14, **caractérisé en ce que**, en état monté, une douille d'écartement (49) est disposée entre le premier écrou (36), accommodant la vis de fixation (11), et le deuxième écrou (43), fixant le support (3).

16. Dispositif de fixation selon l'une des revendications 1 à 15, **caractérisé en ce que** le membre de serrage extérieur (4) est formé comme un disque de serrage.

17. Dispositif de fixation selon l'une des revendications 1 à 15, **caractérisé en ce que** le membre de serrage extérieur (4) est formé comme un boulon à tête fraisée.

18. Dispositif de fixation selon l'une des revendications 1 à 17, **caractérisé en ce que** le dispositif de fixation (107) comprend deux disques de support (108, 109) que l'on peut coupler - de préférence visser -, entre lesquels la vitre en verre (101) est maintenue en état monté, les lignes pour la transmission de courant entrant radialement entre les disques de support (108, 109) et sortant axialement sur l'un des disques de support (108).

19. Dispositif de fixation selon la revendication 18, **caractérisé en ce que** chaque disque de support (108, 109) présente un épaulement cylindrique (113, 114), qui, en état monté, fait saillie jusque dans un évidement (106) de la vitre en verre (101).

20. Dispositif de fixation selon l'une des revendications 18 ou 19, **caractérisé en ce que** les disques de support (108, 109) sont vissés par l'intermédiaire de vis séparées (110), qui sont logées de préférence dans la région des épaulements cylindriques (113, 114).

21. Dispositif de fixation selon l'une des revendications 1 à 20, **caractérisé en ce que** les lignes pour la transmission de courant présentent des accouplements (125) dans la région des disques de support (108, 109).

22. Dispositif de fixation selon l'une des revendications 18 à 21, **caractérisé en ce que** l'un des disques de support (108) est maintenu par une vis de fixation (120), qui est exécutée comme un cylindre creux, et à travers laquelle sont conduits les câbles (124) des lignes pour la transmission de courant des panneaux voltaïques (104).

23. Dispositif de fixation selon la revendication 22, **caractérisé en ce que** la vis de fixation (120) maintient le disque de support (108) en le serrant.

24. Dispositif de fixation selon la revendication 23, **caractérisé en ce que** la vis de fixation (120) fait saillie jusqu'à travers une fente longitudinale (119) du disque de support (108).

25. Dispositif de fixation selon l'une des revendications 18 à 24, **caractérisé en ce que** l'un des disques de support (109) présente une ouverture axiale (117), qui est couverte par une cache (116).

26. Dispositif de fixation selon la revendication 25, **caractérisé en ce que** l'ouverture (117) est pourvue d'un taraudage dans lequel se visse une partie en saillie (118) en forme de boulon de la cache (116).

27. Dispositif de fixation selon l'une des revendications 24 à 26, **caractérisé en ce que** la vis de fixation (120) est pourvue d'un six pans creux (127).

28. Dispositif de fixation selon l'une des revendications 22 à 27, **caractérisé en ce qu'**une vis d'ajustement de la cloche d'accouplement (203) et une vis pendulaire (205), qui peut être reliée avec la vis de fixation (120) et qui est serrée par un écrou d'accouplement (204), présentent un perçage central (206) pour l'accommodation d'un tuyau flexible (208).
